# FASCICULE DE BREVET EUROPEEN

(11) **EP 3 107 124 B1**
(45) Date de publication et mention de la délivrance du brevet: **04.04.2018**
(21) Numéro de dépôt: 16151402.1
(22) Date de dépôt: 15.01.2016
(51) Int. Cl.: H01L 29/66, H01L 21/3065, H01L 21/8238, H01L 21/8234, H01L 21/84, H01L 27/12

(54) **PROCÉDÉ DE FORMATION DES ESPACEURS D'UNE GRILLE D'UN TRANSISTOR**
VERFAHREN ZUR BILDUNG VON ABSTANDSHALTERN EINES GATES EINES TRANSISTORS
METHOD FOR FORMING SPACERS OF A TRANSISTOR GATE

(30) Priorité: 19.06.2015 FR 1555666
(43) Date de publication de la demande: 21.12.2016
(73) Titulaire: COMMISSARIAT À L'ÉNERGIE ATOMIQUE ET AUX ÉNERGIES ALTERNATIVES, 75015 Paris (FR)
(72) Inventeur: POSSEME, Nicolas, 38360 Sassenage (FR)
(74) Mandataire: Hautier, Nicolas

(56) Documents cités:
- EP-A1- 2 750 170
- US-A1- 2004 014 305
- US-A1- 2007 232 006
- US-A1- 2013 252 430
- ROMUALD BLANC ET AL: "Patterning of silicon nitride for CMOS gate spacer technology. I. Mechanisms involved in the silicon consumption in CH3F/O2/He high density plasmas", JOURNAL OF VACUUM SCIENCE & TECHNOLOGY B: MICROELECTRONICS AND NANOMETER STRUCTURES, vol. 31, no. 5, 1 janvier 2013 (2013-01-01), page 051801, XP055171054, ISSN: 2166-2746, DOI: 10.1116/1.4816466

## Description

### DOMAINE TECHNIQUE DE L'INVENTION

La présente invention concerne en général les transistors à effet de champs (FET) utilisés par l'industrie de la microélectronique et plus particulièrement la réalisation des espaceurs de grille des transistors de type métal-oxyde-semiconducteur (MOSFET) majoritairement utilisés pour la production de toutes sortes de circuits intégrés.

### ÉTAT DE LA TECHNIQUE

La course incessante à la réduction des dimensions qui caractérise toute l'industrie de la microélectronique n'a pu se faire qu'avec l'apport d'innovations clés tout au long de décennies de développement depuis que les premiers circuits intégrés ont été produits industriellement dans les années soixante. Une innovation très importante qui remonte aux années soixante-dix, et qui est toujours utilisée, consiste à réaliser les transistors MOSFET à l'aide d'une technique dans laquelle les électrodes de source et de drain sont auto alignés sur celles de grille et ne nécessitent donc pas d'opération de photogravure pour leur définition. Combiné avec l'utilisation de grilles en silicium polycristallin, ce sont les grilles elles-mêmes, réalisées en premier, qui servent de masque lors du dopage des zones de source et drain des transistors.

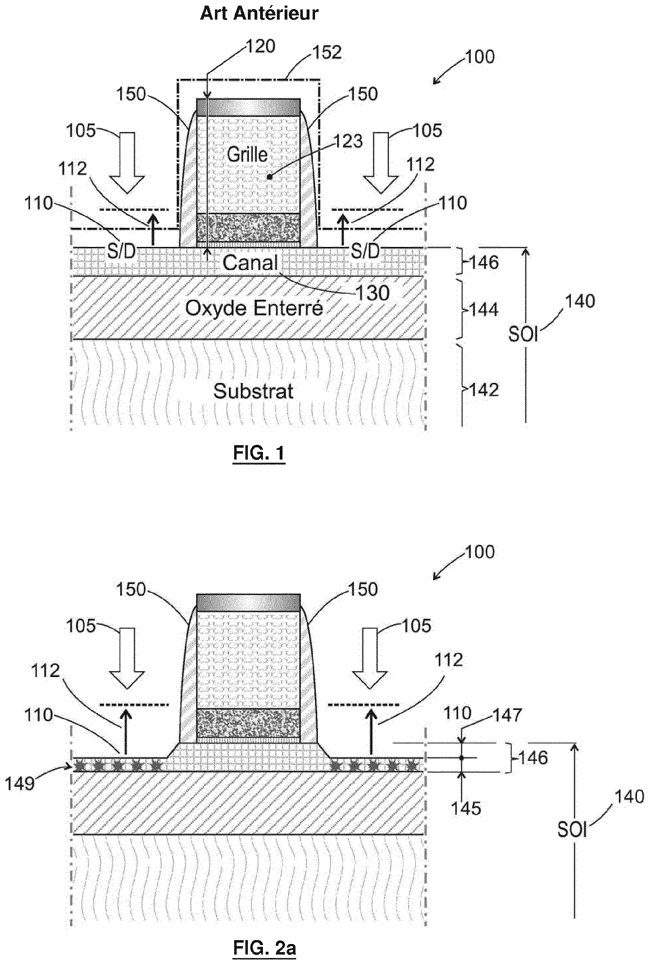

La **figure 1** est une vue en coupe d'un exemple de ce type de transistor 100 en cours de réalisation. On y retrouve les zones de source et de drain 110, globalement désignées zones source/drain, puisqu'elles sont très généralement parfaitement symétriques et peuvent jouer les deux rôles en fonction des polarisations électriques qui sont appliquées au transistor. La grille est classiquement constituée d'un empilement de couches 120 dont une grande partie est toujours constituée de silicium polycristallin 123. La formation des zones de source et drain se fait typiquement par implantation ionique 105 de dopants dans les zones 110, la grille 120 servant de masque comme mentionné ci-dessus, empêchant ainsi le dopage de la zone du transistor MOSFET dans laquelle, en fonction des tensions appliquées sur la grille, va pouvoir se développer le canal 130 de conduction entre source et drain.

La technique de base, très brièvement décrite ci-dessus, bien connue de l'homme du métier ainsi que de nombreuses variantes, a été constamment perfectionnée dans le but d'améliorer les performances électriques des transistors tout en permettant d'accommoder les réductions de taille successives des transistors nécessitées par une intégration toujours croissante d'un plus grand nombre de composants dans un circuit intégré.

Une technique largement utilisée actuellement consiste à fabriquer les circuits intégrés en partant de substrats élaborés 140 de type silicium sur isolant, désignés par leur acronyme SOI, de l'anglais « silicon on insulator ». Le substrat élaboré SOI est caractérisé par la présence d'une fine couche superficielle de silicium monocristallin 146 reposant sur une couche continue d'oxyde de silicium 144, dit oxyde enterré ou encore BOX, acronyme de l'anglais « buried oxide layer ». La solidité et la rigidité mécanique de l'ensemble sont assurées par la couche 142 qui constitue le corps du substrat SOI, souvent qualifié du vocable anglais de « bulk » pour indiquer que le substrat de départ est très généralement fait de silicium massif. Cette structure offre de nombreux avantages pour la réalisation des transistors MOSFET. Notamment, elle permet une réduction drastique des capacités parasites en raison de la présence de la couche continue isolante 144. En ce qui concerne l'invention, on retiendra seulement que la couche superficielle de silicium monocristallin 146 peut être contrôlée précisément en épaisseur et en dopage. En particulier, il est avantageux pour les performances des transistors que le canal 130 puisse être complètement déserté de porteurs, c'est-à-dire « fully depleted » (FD), vocable anglais qui est généralement utilisé pour désigner cet état. Ceci est obtenu en réalisant les transistors à partir de substrats SOI dont la couche superficielle 146 est très mince ce qui n'est pas sans inconvénient par ailleurs comme on le verra dans la description de l'invention. Ce type de transistor est ainsi désigné par l'acronyme FDSOI.

Un perfectionnement de la technique de base d'auto alignement qui a été universellement adopté consiste en la formation d'espaceurs 150 sur les flancs de la grille. Les espaceurs 150, typiquement faits de nitrure de silicium (SiN), vont permettre en particulier la mise en oeuvre d'une technique dite de « Source et Drain surélevés ». Pour pouvoir maintenir de faibles résistances électriques d'accès aux électrodes de source et de drain, en dépit de la réduction de taille des transistors, il a fallu en effet augmenter leur section. Ceci est obtenu par épitaxie sélective des zones source/drain 110. Au cours de cette opération on va faire croître 112 localement la couche initiale de silicium monocristallin 146. Il faut alors protéger les zones de grilles pour empêcher la croissance de se faire également à partir du silicium polycristallin 123 de la grille. C'est, entre autres, le rôle des espaceurs que d'assurer cette fonction. Ils assurent également un rôle de préservation de la grille lors de la siliciuration des contacts (non représentée) qui est ensuite effectuée dans le même but afin de diminuer la résistance série d'accès aux électrodes du transistor.

La formation des espaceurs 150 est devenue une étape cruciale de formation des transistors qui atteignent désormais des dimensions qui se mesurent couramment en nanomètres (nm = 10⁻⁹ mètres) et qui sont globalement de tailles décananométriques. La réalisation des espaceurs se fait sans faire intervenir aucune opération de photogravure. Ils sont auto alignés sur la grille 120 à partir du dépôt d'une couche uniforme de nitrure de silicium 152 (SiN) qui subit ensuite une gravure très fortement anisotrope. Cette gravure du SiN attaque préférentiellement les surfaces horizontales, c'est-à-dire toutes les surfaces qui sont parallèles au plan du substrat SOI. Elle ne laisse en place, imparfaitement, que les parties verticales de la couche 152, celles sensiblement perpendiculaires au plan du substrat, afin d'obtenir en pratique les motifs 150 dont la forme idéale serait évidemment rectangulaire. Un exemple de procédé de formation d'espaceurs est fourni par le document EP2750170-A1.

Avec les solutions connues, la réduction de taille des transistors rend très délicate l'obtention d'espaceurs jouant pleinement leur rôle d'isolation et n'induisant pas de défauts dans la réalisation de transistors à partir de substrats SOI. En effet, dans le cadre de la présente invention, et comme cela sera détaillé par la suite, il a été constaté que plusieurs types de défaut tels que ceux mentionnés ci-dessous apparaissent lors de la gravure des espaceurs en utilisant l'un ou l'autre des procédés connus de gravure anisotrope.

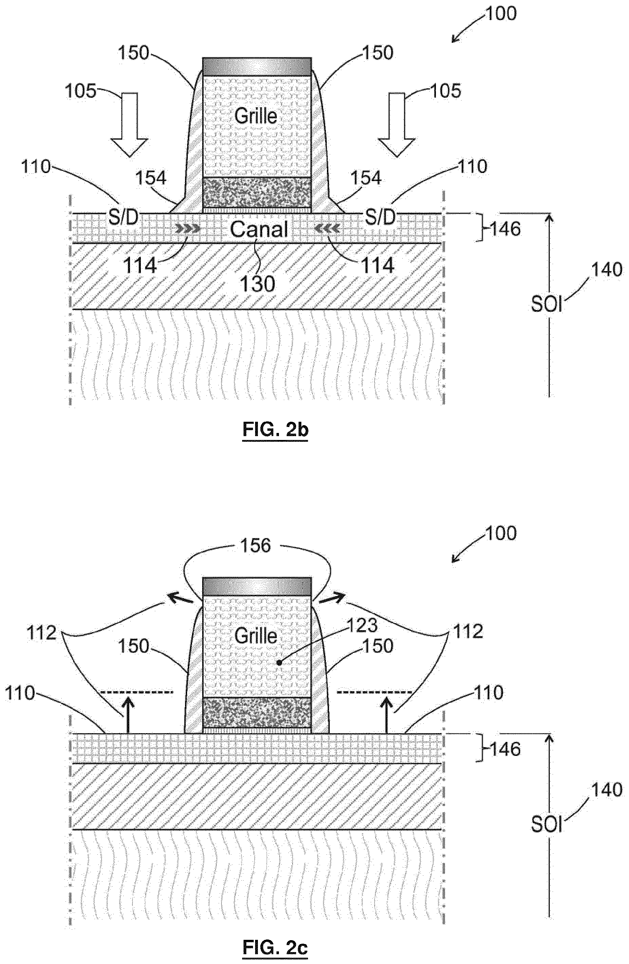

Les **figures 2a****,** **2b et 2c** illustrent chacune un type de défaut observé. On utilise notamment un type de gravure qui est dite « sèche » et qui se met en oeuvre à l'aide d'un procédé qui est le plus souvent désigné par son acronyme RIE, de l'anglais « reactive-ion eching », c'est-à-dire : « gravure ionique réactive ». Il s'agit d'un procédé de gravure dans lequel on forme, dans une enceinte confinée, un plasma qui réagit physiquement et chimiquement avec la surface de la tranche à graver. Dans le cas de la gravure d'une couche de nitrure de silicium, qui est comme on l'a vu le matériau préféré pour la réalisation des espaceurs, le gaz réactif est typiquement le fluorure de méthyle (CH3F) que l'on fait réagir avec le matériau à graver en introduisant également du dioxygène (O2). On forme ainsi un plasma de gravure basé sur la chimie du fluor et souvent désigné par ses constituants : CH3F/O2/He. Dans ce plasma le composé fluor sert à graver le nitrure de silicium tandis que l'oxygène permet de limiter la polymérisation du fluorure de méthyle et sert également à oxyder le silicium lorsque ce matériau est atteint en cours de gravure. La couche d'oxyde formée sur le silicium permet de ralentir la gravure du silicium au prix cependant d'une transformation en surface de ce dernier en oxyde et donc d'une consommation superficielle de silicium. L'hélium sert de diluant pour l'oxygène.

L'avantage de ce type de gravure est qu'elle est assez anisotrope et permet de contrôler suffisamment le profil des espaceurs 150 même si l'on ne peut pas obtenir en pratique la forme rectangulaire idéale. L'inconvénient de ce type de gravure est que la sélectivité d'attaque du silicium sous-jacent est cependant limitée. La sélectivité, c'est-à-dire le rapport des vitesses de gravure entre le nitrure de silicium et le silicium est de l'ordre de 10 et peut atteindre 15 au maximum en fonction des conditions de formation du plasma (le nitrure est gravé 10 à 15 fois plus vite que le silicium).

On utilise aussi des gravures dites « humides » à base d'acide fluorhydrique (HF) ou d'acide phosphorique (H3PO4), ce dernier en particulier pour le SiN ou le SiC, qui ont une bien meilleure sélectivité, respectivement, vis-à-vis du silicium ou de son oxyde (SiO2) mais qui ne permettent pas cependant de contrôler le profil des espaceurs puisque la gravure est essentiellement isotrope dans ce cas. On notera ici que ce type de gravure est aussi qualifié de « nettoyage humide » traduction de l'anglais « wet clean ».

On notera ici qu'il existe de nombreuses publications sur le sujet de la gravure du nitrure de silicium et/ou des espaceurs de grille en général. On pourra se référer par exemple aux brevets ou demandes de brevets américains suivants : 2003/0207585 ; 4 529 476 ; 5 786 276 et 7 288 482.

La **figure 2a** illustre un premier problème qui est en relation avec la sélectivité insuffisante d'attaque qui existe lors d'une gravure sèche de type CH3F/O2/He entre le nitrure de silicium et le silicium de la couche superficielle 146. Le résultat est qu'une fraction significative de la mince couche superficielle de silicium monocristallin 146 du substrat SOI peut être alors partiellement consommée 147 lors de la gravure anisotrope du nitrure. Comme précédemment mentionné, la couche superficielle 146 est choisie pour être de faible épaisseur afin d'améliorer les caractéristiques électriques des transistors. Elle est typiquement inférieure à 10 nm. L'épaisseur restante 145 peut être très faible. Dans ces conditions l'implantation ionique 105 pour former les zones de source et de drain 110 qui va suivre est susceptible d'être très dommageable pour le silicium monocristallin restant. L'énergie d'implantation des dopants peut être suffisante pour provoquer une amorphisation complète 149 du silicium monocristallin ce qui va alors notamment compromettre l'étape de croissance épitaxiale 112 suivante destinée à former les source/drain surélevés. Comme précédemment mentionné, cette dernière opération est rendue nécessaire en raison de la diminution de taille des transistors afin de pouvoir maintenir les résistances d'accès aux électrodes de source et de drain à des valeurs suffisamment faibles pour ne pas impacter le fonctionnement électrique des transistors. Une croissance à partir d'une couche de silicium partiellement ou totalement rendue amorphe va créer de nombreux défauts dans la couche formée par épitaxie.

La **figure 2b** illustre un autre problème où il n'y a pas consommation significative du silicium de la couche superficielle 146 mais il y a formation de « pieds » 154 au bas des motifs de nitrure de silicium restants sur les flancs de la grille après gravure. La conséquence est que la transition 114 des jonctions qui sont formées après dopage par implantation ionique 105 des zones de source et drain 110, avec la zone du canal 130, est beaucoup moins abrupte que lorsque les espaceurs n'ont pas de pieds comme représenté dans les figures précédentes. La présence de pieds 154 affecte les caractéristiques électriques des transistors. On remarquera ici que la formation ou non de pieds au bas des espaceurs et la consommation ou non de silicium de la couche superficiel de silicium 146 du substrat SOI, décrite dans la figure précédente, sont des paramètres de réglage antagonistes de la gravure qui nécessitent qu'un compromis puisse être trouvé pour lequel, idéalement, on ne forme pas de pieds et on n'attaque pas significativement la couche superficielle de silicium.

La **figure 2c** illustre un troisième problème qui se produit quand la gravure produit une érosion trop importante des espaceurs dans les parties hautes des grilles et met à nu le silicium polycristallin 123 dans ces zones 156. La conséquence est que la croissance épitaxiale 112 ultérieure pour former les source/drain surélevés va aussi se produire à ces endroits, ainsi qu'une siliciuration de contacts parasites, ce qui risque de provoquer des courts circuits entre électrodes. En effet, la gravure des espaceurs demande que le temps de gravure soit ajusté pour graver, par exemple, 150% de l'épaisseur de nitrure déposé. C'est-à-dire que l'on pratique une surgravure de 50% dans cet exemple afin de tenir compte de la non uniformité du dépôt, ou de l'opération de gravure elle-même, au niveau d'une tranche. Ainsi, dans certaines parties de la tranche on pourra constater qu'il y a une surgravure trop prononcée qui met à nu les zones de grille 156. Ce type de défaut est aussi qualifié de « facettage ».

De plus, pour certaines applications il peut être nécessaire de prévoir une couche de protection souvent à base de carbone telle un masque ou une résine photosensible (de l'anglais « photoresist ») ou thermosensible afin de protéger lors de la gravure des espaceurs des structures formées sur le substrat. Tel est par exemple le cas lors de la réalisation de transistors PMOS proches de transistors NMOS dont les espaceurs sont en cours de réalisation. Les procédés connus de gravure peuvent conduire à une forte consommation de cette couche de protection lors de la gravure des espaceurs du transistor PMOS.

La présente invention a pour objet de proposer un procédé de formation d'espaceurs jouant pleinement leur rôle d'isolation et qui supprimerait ou limiterait au moins certains des défauts dans la réalisation de transistors, tels que la consommation ou l'altération du matériau semi-conducteur (i.e. Si, SiGe) de la couche active, la formation de « pieds » au bas des motifs sur les flancs de la grille d'un transistor, la consommation d'une couche de protection à base de carbone etc.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de formation des espaceurs d'une grille d'un transistor à effet de champ, la grille étant située au-dessus d'une couche active en un matériau semi-conducteur, comprenant : une étape de formation d'une couche de protection recouvrant la grille dudit transistor ; au moins une étape de modification de la couche de protection, réalisée après l'étape de formation de la couche de protection, par mise en présence de la couche de protection avec un plasma comprenant des ions plus lourds que l'hydrogène et du CxHy où x est la proportion de carbone et y est la proportion d'hydrogène pour former une couche de protection modifiée et former un film carboné.

Avantageusement, la couche de protection est une couche à base de nitrure (N) et/ou à base de silicium (Si) et/ou base de carbone (C).

Avantageusement, la couche de protection présente une constante diélectrique égale ou inférieure à 8 et de préférence égale ou inférieure 7.

L'étape de modification est réalisée de manière à ce que le plasma provoque un bombardement anisotrope d'ions à base d'hydrogène provenant du CxHy selon une direction principale d'implantation parallèle à des flancs de la grille et de sorte à former une couche de protection modifiée en modifiant des portions de la couche de protection situées sur le sommet de la grille et de part et d'autre de la grille et de sorte à conserver des portions non modifiées, ou tout au moins non modifiées sur toute leur épaisseur, de la couche de protection recouvrant les flancs de la grille.

Les ions à base d'hydrogène sont de préférence pris parmi : H, H⁺, H₂⁺, H₃⁺.

Un film carboné est un film comprenant des espèces chimiques contenant du carbone. Selon un mode de réalisation non limitatif le film carboné est en carbone. Avantageusement, le film carboné peut contribuer à protéger les flancs de la grille lors du bombardement en évitant que de l'hydrogène ou des ions lourds ne viennent modifier la couche de protection ou ne viennent le modifier sur toute son épaisseur.

De manière très avantageuse, le film carboné contribue à protéger la couche de protection non modifiée au niveau des flancs lors de la gravure de la couche de protection modifiée par HF par exemple.

L'étape de modification est réalisée de manière à former un film carboné notamment sur des surfaces parallèles à la direction principale d'implantation également désignée direction du bombardement.

Le procédé comprend également au moins une étape de retrait de la couche de protection modifiée à l'aide d'une gravure sélective de la couche de protection modifiée vis-à-vis dudit film carboné et vis-à-vis des portions non-modifiées de la couche de protection.

Lesdites portions non-modifiées peuvent ainsi constituer les espaceurs pour la grille.

De manière particulièrement avantageuse, il a été constaté que le bombardement d'ions plus lourds que l'hydrogène tels que l'He permet aux espèces chimiques du plasma contenant du carbone provenant du CxHy de former un film protecteur de carbone (film carboné) notamment sur des surfaces parallèles à la direction du bombardement et tout en empêchant par ailleurs à ces espèces chimiques contenant du carbone de former un film carboné sur les surfaces de la couche de protection qui sont perpendiculaires à la direction du bombardement.

Le bombardement d'ions plus lourds que l'hydrogène détruit en effet le film carboné qui aurait tendance à se déposer sur les surfaces perpendiculaires à la direction du bombardement.

Lors de l'étape de retrait, cette gravure grave les surfaces de la couche de protection modifiée qui ne sont pas recouvertes du film carboné.

Ainsi, il est possible de protéger une structure sur laquelle le film carboné se forme.

En outre, il a été constaté que le bombardement ionique n'empêche pas la formation de ce film carboné lorsque lorsqu'on met en présence une couche comportant du carbone avec le plasma. Ce film carboné fait alors office de film de protection qui empêche la modification de la couche carbonée recouverte par le film. Par ailleurs, la gravure étant sélective de la couche de protection modifiée par rapport au carbone, le film carboné formé sur la couche carbonée protège cette dernière lors de l'étape de retrait.

De manière particulièrement avantageuse, la modification de la couche de protection par bombardement d'ions hydrogène (H) conduit à implanter ces ions à base d'hydrogène dans les couches visées. Cette modification par implantation d'ions permet d'améliorer considérablement la sélectivité de la gravure de cette couche par rapport au matériau semi-conducteur, typiquement du silicium. Cette implantation fait également que l'épaisseur de couche de protection modifiée se grave plus rapidement que la couche de protection non modifiée.

La gravure consomme ainsi la couche de protection modifiée préférentiellement à la couche de matériau semi-conducteur et aux portions non modifiées de la couche de protection. Ainsi, le risque de consommation excessive de la couche superficielle de matériau semi-conducteur est réduit voir supprimé.

De préférence, la modification de la couche de protection conserve une épaisseur partielle ou complète de couche de protection non modifiée sur les flancs de la grille. Cette épaisseur est conservée, au moins en partie, lors de la gravure sélective. Elle définit alors des espaceurs de grille.

Par ailleurs, le film carboné contribue à protéger la couche de protection non modifiée au niveau des flancs lors de la gravure de la couche de protection modifiée.

L'invention permet ainsi d'obtenir des espaceurs tout en réduisant voire en éliminant les problèmes des solutions connues et mentionnés précédemment. En particulier, si une couche ou un bloc comprenant du carbone est présente. Cette couche à base de carbone n'est pas consommée par la gravure. Il peut par exemple s'agir d'un masque dur de carbone. Il peut également d'agir d'une résine à base de carbone disposée de manière à protéger de la gravure et du plasma une structure réalisée au préalable.

L'implantation réalisée à partir d'un plasma comprenant lesdits ions à base d'hydrogène a pour avantage de permettre une implantation de manière continue dans un volume s'étendant dès la surface de la couche implantée.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à 100 nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30 nm. Dans le cadre du développement de la présente invention, il a été remarqué que les implanteurs ne permettent alors pas d'obtenir une vitesse de gravure suffisamment constante de la couche de protection modifiée et ce depuis la surface de cette dernière, conduisant ainsi à une moindre précision de gravure comparé à ce que permet l'invention.

L'utilisation d'un plasma pour modifier la couche à retirer est donc particulièrement avantageuse dans le cadre de l'invention qui vise à retirer une fine épaisseur de la couche de protection, typiquement comprise entre 1 et 10 nm et plus généralement entre 1 et 30 nm.

L'étape de modification réalisée à partir d'un plasma modifie la couche de protection de manière continue depuis la surface de la couche de protection et sur une épaisseur comprise entre 1 nm et 30 nm et de préférence entre 1 nm et 10 nm.

De manière également avantageuse, la modification de la couche de protection par implantation d'ions à base d'hydrogène permet également d'améliorer la sélectivité de cette couche de protection modifiée par rapport à l'oxyde du matériau semi-conducteur.

Ainsi, lors de l'étape de modification les conditions du plasma, en particulier la concentration en CxHy, l'énergie des ions et la direction principale d'implantation sont choisies de manière à ce que :
- le plasma crée un bombardement d'ions à base d'hydrogène (H) provenant de CxHy anisotrope selon une direction privilégiée parallèle à des flancs de la grille et de sorte à modifier des portions de la couche de protection en dehors des flancs de la grille et tout en conservant des portions non modifiées, ou tout au moins non modifiées sur toute leur épaisseur, de la couche de protection recouvrant les flancs de la grille,
- des espèces chimiques du plasma contenant du carbone provenant du CxHy forment un film carboné notamment sur des surfaces parallèles à la direction du bombardement ;
- le plasma crée un bombardement des ions plus lourds que l'hydrogène qui empêche aux espèces chimiques contenant du carbone provenant du CxHy de former un film carboné notamment sur les surfaces de la couche de protection qui sont perpendiculaires à la direction du bombardement.

Sont énoncées ci-après des caractéristiques optionnelles qui peuvent éventuellement être utilisées en association ou alternativement avec les caractéristiques ci-dessus:
Le bombardement d'ions plus lourds que l'hydrogène (désignés par la suite « ions lourds »), en particulier son énergie, sa direction et sa fluence sont prévues de sorte que le film carboné se forme sur les surfaces parallèles à la direction d'implantation et de sorte que le film carboné ne se forme pas sur les surfaces de la couche de protection qui sont perpendiculaires à la direction d'implantation. Plus précisément, le bombardement ionique consomme, de manière très anisotrope, les espèces chimiques contenant du carbone qui se déposent sur le fond des structures. Le bombardement suivant une direction perpendiculaire à la direction d'implantation (c'est-à-dire au niveau des flancs) est très faible. L'énergie des ions n'est donc pas suffisante pour empêcher la formation de ce film carboné.

De manière avantageuse mais non limitative, le procédé comprend, préalablement à l'étape de modification et de préférence après l'étape de formation de la couche de protection, une étape de dépôt d'une couche comprenant du carbone.

Le film carboné agit comme un film de protection pour la couche de carbone empêchant ou réduisant la modification de cette dernière sous l'effet du bombardement ionique. La couche de carbone peut éventuellement être modifiée lors de l'étape de modification, mais elle n'est pas retirée par le HF.

Cette couche comprenant du carbone est distincte du transistor pour lequel on réalise les espaceurs.

Cette couche comprenant du carbone forme par exemple un bloc de masquage d'une structure réalisée au préalable.

Il s'est avéré qu'en sélectionnant l'énergie des ions et la densité de CxHy la couche de carbone n'est pas sensiblement modifiée par l'implantation des ions plus lourds que l'hydrogène même sur ses surfaces perpendiculaires à la direction privilégiée du bombardement. Il s'est avéré que le carbone provenant du CxHy réagit avec le carbone de la couche comprenant du carbone pour former en surface une couche de carbone suffisamment épaisse et dense pour résister au bombardement d'ions, et ceci même sur les surfaces de la couche de carbone qui sont perpendiculaires à la direction privilégiée du bombardement.
Plus précisément, en raison des affinités chimiques entre la couche comprenant du carbone et le carbone du plasma, ce dernier se dépose sur la couche comprenant du carbone rapidement et avant d'être pulvérisé. Ces affinités chimiques permettent d'atteindre rapidement un régime de dépôt et la couche comprenant du carbone n'est ainsi pas consommée.
Ainsi l'invention est particulièrement avantageuse pour réaliser des structures différentes sur un même substrat, par exemple un transistor NMOS adjacent à un transistor PMOS.

De préférence, la couche comprenant du carbone est une couche de résine photosensible ou thermosensible. Un transistor NMOS par exemple peut être recouvert d'une résine à base de carbone tandis qu'un transistor PMOS n'est pas recouvert par la résine. La résine protège le transistor NMOS lors de l'étape de modification et de gravure de la couche de protection du transistor PMOS.

Dans un autre mode de réalisation, cette couche comprenant du carbone est un masque dur de préférence formé de carbone.

Dans un mode de réalisation avantageux, ladite couche comprenant du carbone est configurée pour recouvrir une structure distincte dudit transistor, ladite structure et le transistor étant sur un même substrat.

De préférence, ladite structure est située au-dessus de ladite couche active en un matériau semi-conducteur.

De préférence, ledit transistor est un transistor NMOS et ladite structure est un transistor PMOS. Dans un autre mode de réalisation préféré, ledit transistor est un transistor PMOS et ladite structure est un transistor NMOS.

Préférentiellement, lors de l'étape de modification réalisée par mise en présence de la couche de protection avec le plasma comprenant du CxHy, le film carboné recouvre les parois de la couche comprenant du carbone, l'épaisseur e2 du film carboné recouvrant les parois de la couche comprenant du carbone étant supérieure à l'épaisseur e1 du film carboné au niveau des flancs de la grille.

Ainsi le film carboné d'épaisseur e2 résiste au bombardement des ions, ce qui permet de protéger la couche comprenant du carbone lors de l'étape de modification ainsi que lors de l'étape de retrait. De plus, l'étape de retrait ne conduit donc pas à une consommation de la couche comprenant du carbone.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 illustre une vue en coupe d'un exemple de transistor MOSFET de type FDSOI en cours de réalisation.
Les FIGURES 2a à 2c illustrent différents défauts qui peuvent être observés sur des structures de transistors FDSOI lors de la gravure des espaceurs en utilisant l'un ou l'autre des procédés standard de gravure anisotrope développés par l'industrie de la microélectronique.
La FIGURE 3 résume les principales étapes d'un exemple de procédé de formation des espaceurs d'un transistor selon l'invention appliqué à la réalisation de transistors.
Les FIGURES 4a à 4d illustrent les structures d'un transistor obtenues à l'issue des certaines des étapes du procédé selon un mode de réalisation de l'invention.
Les FIGURES 5a, 5b et 5e illustrent respectivement une structure d'un transistor obtenue à l'issue d'une des étapes du procédé selon un autre mode de réalisation de l'invention. Les FIGURES 5a, 5c à 5e illustrent respectivement une structure d'un transistor obtenue à l'issue d'une des étapes du procédé selon un mode de réalisation différent des deux modes de réalisation illustrés précédemment.
La FIGURE 6 illustre les étapes du retrait par voie sèche de la couche de protection modifiée.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DÉTAILLÉE DE L'INVENTION

Il est précisé que dans le cadre de la présente invention, le terme « sur », « surmonte », « recouvrir » ou « sous-jacent » ou leurs équivalents ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

De manière classique, la constante diélectrique d'une couche peut se mesurer par exemple selon la méthode dite de la goutte de mercure

On rappellera que selon un aspect l'invention porte sur un procédé de formation d'espaceurs d'une grille d'un transistor à effet de champ, la grille étant située au-dessus d'une couche active en un matériau semi-conducteur, le procédé comprenant :
- au moins une étape de formation d'une couche de protection recouvrant la grille dudit transistor, la couche de protection étant une couche à base de nitrure (N) et/ou de silicium (Si) et/ou de carbone (C) qui présente une constante diélectrique égale ou inférieure à 8 et de préférence à 7 ;
- au moins une étape de modification de la couche de protection par mise en présence de la couche de protection avec un plasma dans lequel on introduit du CxHy où x est la proportion de carbone et y est la proportion d'hydrogène (H) et comprenant des ions plus lourds que l'hydrogène ; les conditions du plasma, en particulier la concentration en CxHy, l'énergie des ions et la direction principale d'implantation étant choisies de manière à ce que :
   o le plasma créé un bombardement d'ions à base d'hydrogène (H, H⁺, H₂⁺, H₃⁺ etc.) provenant du CxHy, le bombardement étant anisotrope selon une direction privilégiée parallèle à des flancs de la grille et de sorte à former une couche de protection modifiée en modifiant uniquement une portion supérieure de l'épaisseur de la couche de protection au niveau des flancs de la grille et de sorte à conserver des portions non-modifiées de la couche de protection recouvrant les flancs de la grille,
   o des espèces chimiques du plasma contenant du carbone provenant du CxHy forment un film carboné notamment sur des surfaces parallèles à la direction du bombardement ;
   o le plasma créé un bombardement des ions plus lourds que l'hydrogène qui empêche audites espèces chimiques du plasma contenant du carbone et provenant du CxHy de former un film carboné notamment sur les surfaces de la couche de protection qui sont perpendiculaires à la direction du bombardement;
   au moins une étape de retrait de la couche de protection modifiée à l'aide d'une gravure sélective de la couche de protection modifiée vis-à-vis des portions non-modifiées de la couche de protection.

Avant d'entamer une revue détaillée de modes de réalisation de l'invention, sont énoncées ci-après des caractéristiques optionnelles qui peuvent éventuellement être utilisées en association ou alternativement :
De manière avantageuse, le CxHy est du CH4.

Les ions plus lourds que l'hydrogène du plasma, pris parmi l'argon (Ar), l'hélium (He), l'azote (N2), le xénon (Xe) et l'oxygène (O2), peuvent être utilisés alternativement ou être combinés dans un même plasma. Leur rôle est d'empêcher la formation du film carboné dans le fond du motif. D'autres ions peuvent convenir.

Les ions à base d'hydrogène sont de préférence pris parmi : H, H⁺, H₂⁺, H₃⁺.

Lors de ladite étape de modification de la couche de protection, le débit de CxHy dans le plasma est compris entre 2% et 50% du débit total et de préférence entre 8% et 40%. Au-delà on sera en mode dépôt. La dilution dépendra du choix des espèces du plasma, He, N2, Ar ou O2 etc. Par exemple :
- pour He ou Ar il faut que le débit de CxHy soit inférieur à 10% du débit total ;
- pour N2 il faut que le débit de CxHy soit inférieur à 20% du débit total ;
- pour 02 il faut que le débit de CxHy soit inférieur à 50% du débit total.

Lors de ladite étape de modification de la couche de protection, la concentration en ions plus lourds que l'hydrogène dans le plasma est comprise entre 50% et 98%.

Avantageusement ces concentrations permettent d'assurer une modification efficace de la couche de protection par les ions à base d'hydrogène tout en permettant la formation d'un film carboné qui protège les flancs de la grille. Ces concentrations permettent également aux ions plus lourds que l'hydrogène d'empêcher la formation du film carboné qui aurait tendance à se déposer sur toutes les surfaces. Par ailleurs, ces concentrations permettent de dissocier efficacement la molécule CxHy afin de libérer l'espèce H.

Selon un mode de réalisation, les paramètres d'implantation, en particulier l'énergie communiquée aux ions, la durée et la dose d'implantation ainsi que la nature des ions sont prévus de sorte que les portions modifiées de la couche à graver puissent être gravées sélectivement par rapport au film carboné. Ces paramètres sont également réglés de manière à ce que les portions modifiées de la couche à graver puissent être gravées sélectivement par rapport aux portions non modifiées de la couche à graver. Ces paramètres sont également réglés de manière à ce que les portions modifiées de la couche à graver puissent être gravées sélectivement par rapport à la couche sous-jacente à la couche à graver.

Dans un mode de réalisation, la couche de protection est préférentiellement une couche à base de nitrure telle qu'une couche de nitrure de silicium.

Dans un autre mode de réalisation, la couche de protection présente ou comprend un matériau présentant une constante diélectrique inférieure à 4 et de préférence inférieure à 3.1 et de préférence inférieure ou égale à 2, ce qui permet ainsi de réduire capacité parasite pour éventuellement améliorer la performance du transistor. Par exemple, le matériau de la couche de protection est pris parmi : le SiCO, le SiC, le SiCN, le SiOCN, le SiCBN, le SiCBO, le SiOCH, le cBN (cubic boron nitride) et le SiO2.

Cela permet de réduire la capacité parasite et d'améliorer en conséquence la performance du transistor.

L'étape de retrait de la couche de protection modifiée, est de préférence effectuée par gravure humide sélective au carbone, aux portions non-modifiées de la couche de protection, et/ou audit matériau semi-conducteur de la couche active et/ou à l'oxyde de silicium (SiO2). Dans ce cas, la couche de protection modifiée est consommée très facilement par rapport à la consommation du carbone, du matériau semi-conducteur de la couche active (typiquement du silicium) et/ou de l'oxyde de silicium (SiO2).

Dans un mode de réalisation où la couche de protection est une couche à base de nitrure, les solutions prévoit en effet une solution de gravure à base d'acide fluorhydrique (HF) qui consomme le nitrure à une vitesse de 0.5 nm/minute et avec une sélectivité du nitrure par rapport au silicium de l'ordre de 20 à 30.

De plus, la sélectivité du nitrure modifié par rapport au carbone et au nitrure non-modifié est respectivement supérieure à 100 et à 30.

Cela permet donc d'améliorer considérablement la sélectivité et donc la précision de la gravure.

On évite ainsi de consommer de manière excessive la couche active et la couche comprenant du carbone, de découvrir les flancs de la grille ou de former des pieds.

D'autres caractéristiques optionnelles de l'invention, qui peuvent être mises en oeuvre de façon combinée selon toutes combinaisons ou de manière alternative, sont indiquées ci-après :
- Avantageusement, la couche de protection est une couche poreuse. Dans le cadre de la présente invention, on désigne par couche poreuse, une couche dont la présence de vide dans le film est supérieure à 5% et de préférence comprise entre 5 et 10%.
- Avantageusement, la couche de protection est une couche non-poreuse.
- Avantageusement, l'étape de formation de la couche de protection comprend une étape de dépôt de la couche de protection au cours de laquelle on réduit la polarisabilité de la couche de protection de manière à réduire la constante diélectrique de cette couche. Selon un mode de réalisation privilégié, on utilise pour cela des liaisons moins polaires que les liaisons formant le matériau de base de la couche de protection.
- L'étape de formation de la couche de protection comprend une étape de dépôt de la couche de protection au cours de laquelle on effectue une étape de réduction de la constante diélectrique de la couche de protection. L'étape de réduction de la constante diélectrique de la couche de protection comprend l'introduction d'une porosité dans la couche de protection. De manière alternative ou combinée à l'introduction d'une porosité, l'étape de formation de la couche à graver comprend l'introduction de précurseurs dans la couche à graver en cours de dépôt. Si la couche à graver est une couche à base de nitrure de silicium, alors les précurseurs sont par exemple choisis de manière à former des liaisons moins polaires que le nitrure de silicium, telles que le Si-F, le SiOF, le Si-O, le C-C, le C-H, et le Si-CH3.
- Avantageusement, l'étape de modification est réalisée de manière à ce que le plasma génère un bombardement des ions plus lourds que l'hydrogène de manière anisotrope selon une direction privilégiée parallèle aux flancs de la grille de sorte à empêcher au carbone provenant du CxHy de former un film carboné sur les surfaces perpendiculaires aux flancs de la grille.
- Avantageusement, l'étape de modification est réalisée de manière à ce que les ions plus lourds que l'hydrogène du plasma dissocient la molécule du CxHy de sorte à permettre aux ions à base d'hydrogène provenant du CxHy de s'implanter dans lesdites portions de la couche de protection. Ainsi, les ions à base d'hydrogène provenant de la molécule CxHy sont dissociés par les ions lourds du plasma. Il s'est avéré que l'hélium (He) est particulièrement efficace pour obtenir cette dissociation du CxHy. Le mélange comprend ainsi un mélange CxHy/He.
- Avantageusement, l'étape de retrait de la couche de protection modifiée est effectuée par gravure sélectivement à la couche active.
- Avantageusement, l'étape de modification de la couche de protection par les ions hydrogène modifie l'intégralité de la couche de protection sur le sommet de la grille et de part et d'autre de la grille.
- Avantageusement, l'étape de modification de la couche de protection par les ions hydrogène ne modifie pas la couche de protection sur les flancs de la grille.
- Avantageusement, les espèces chimique du plasma contenant du carbone provenant du CxHy forment un film carboné uniquement sur les flancs de la grille.
- Avantageusement, lors de l'étape de modification, les conditions du plasma, en particulier la concentration en CxHy, l'énergie des ions et la direction principale d'implantation sont choisies de manière à ce que, au niveau des surfaces perpendiculaires à la direction d'implantation, toute l'épaisseur de la couche de protection soit modifiée par l'implantation des ions à base d'hydrogène. L'étape de retrait est réalisée de manière à retirer toute la couche de protection modifiée, mettant ainsi à nu la couche active au niveau des surfaces perpendiculaires à la direction d'implantation.
- Avantageusement, l'étape de modification est réalisée de manière à modifier uniquement une portion supérieure de l'épaisseur de la couche de protection au niveau des flancs de la grille.
- Avantageusement, l'épaisseur e2 du film carboné recouvrant les parois de la couche comprenant du carbone est deux fois supérieure à l'épaisseur e1 du film carboné au niveau des flancs de la grille.
- Alternativement, l'étape de retrait est effectuée par gravure sèche sélective de ladite couche de protection modifiée vis-à-vis dudit film carboné, vis-à-vis des portions non-modifiées de la couche de protection et vis-à-vis dudit matériau semi-conducteur. En outre la gravure sèche ne prélève pas non plus l'oxyde de silicium (SiO2) formant un masque dur au sommet de la grille.
- De préférence, le matériau semi-conducteur est du silicium, et l'étape de retrait de la couche de protection modifiée est effectuée par gravure sèche sélective au silicium (Si).
- Préférentiellement, la gravure sèche est effectuée dans un plasma formé dans une enceinte confinée à partir de trifluorure d'azote (NF3) et d'ammoniac (NH3).
- Selon un mode de réalisation particulièrement avantageux, l'implantation et le retrait de la couche de protection sont réalisées dans un même réacteur plasma. Une modification de la couche à retirer réalisée par une implantation par plasma permet ainsi d'effectuer la modification de la couche et la gravure dans une même chambre ce qui est très avantageux en termes de simplification, de temps et de coût du procédé.
- Avantageusement, la gravure sèche comprend une étape de gravure consistant en la formation de sels solides ; et une étape de sublimation des espèces solides. Ce mode de réalisation permet d'obtenir une très bonne sélectivité de la gravure de la couche de protection modifiée par rapport aux portions non-modifiées et au matériau semi-conducteur non modifié. En particulier, cette sélectivité de la gravure est très supérieure (typiquement un facteur 10 au moins) à celle obtenue avec une solution de HF.
- De manière préférentielle mais non limitative, le procédé comprend plusieurs séquences comprenant chacune une étape de modification et une étape de retrait, et dans lequel au cours d'au moins l'une des étapes de modification, seule une partie de l'épaisseur de la couche de protection est modifiée.
- Les séquences sont de préférence répétées jusqu'à disparition de la couche de protection modifiée sur toutes les surfaces parallèles au plan d'un substrat sur lequel repose la grille.
- Dans un mode de réalisation, l'étape de modification est une unique étape effectuée de manière à modifier la couche de protection dans toute son épaisseur sur toutes les surfaces parallèles au plan d'un substrat sur lequel repose la grille et à ne pas modifier la couche de protection dans toute son épaisseur sur les surfaces perpendiculaires à ce plan. Ce mode de réalisation permet un contrôle particulièrement précis de la dimension des espaceurs.
- De manière préférentielle mais non limitative, l'étape de modification est précédée d'une étape de gravure anisotrope qui est effectuée dans un plasma de type CH3F/O2/He. Ce mode de réalisation permet d'enlever beaucoup de la couche de protection en une étape puis d'affiner le contrôle de l'épaisseur sur les flancs au cours d'une deuxième étape. Ce mode de réalisation permet ainsi de réduire le temps de fabrication.
- La grille du transistor est située sur un empilement de couches formant un substrat élaboré de type silicium sur isolant (SOI).
- L'étape de retrait est effectuée par gravure de la couche de protection modifiée sélectivement au film carboné.
- Le matériau semi-conducteur est pris parmi: le silicium (Si), le germanium (Ge), le silicium-germanium (SiGe). L'étape de retrait de la couche de protection de silicium modifiée est effectuée par gravure humide sélectivement au Ge ou au SiGe ou et/ou à de l'oxyde de SiGe ou de l'oxyde de Ge.
- L'étape de modification réalisée à partir d'un plasma modifie la couche de protection de manière continue depuis la surface de la couche de protection et sur une épaisseur comprise entre 1 nm et 30 nm et de préférence entre 1nm et 10 nm.
- Selon un mode de réalisation non limitatif, le transistor est un transistor de type FDSOI ou FinFET.

Comme on l'a vu un objet de l'invention est de s'affranchir de tous ou d'au moins certains des problèmes mentionnés ci-dessus.

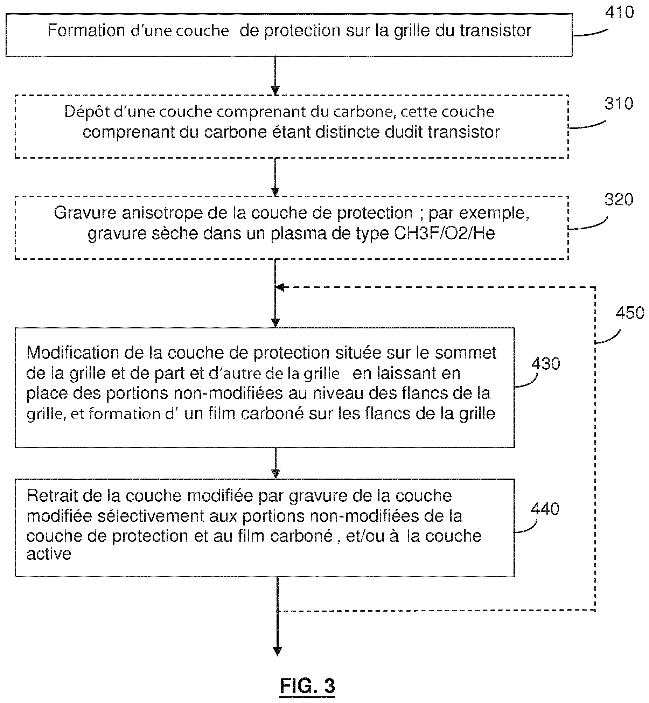

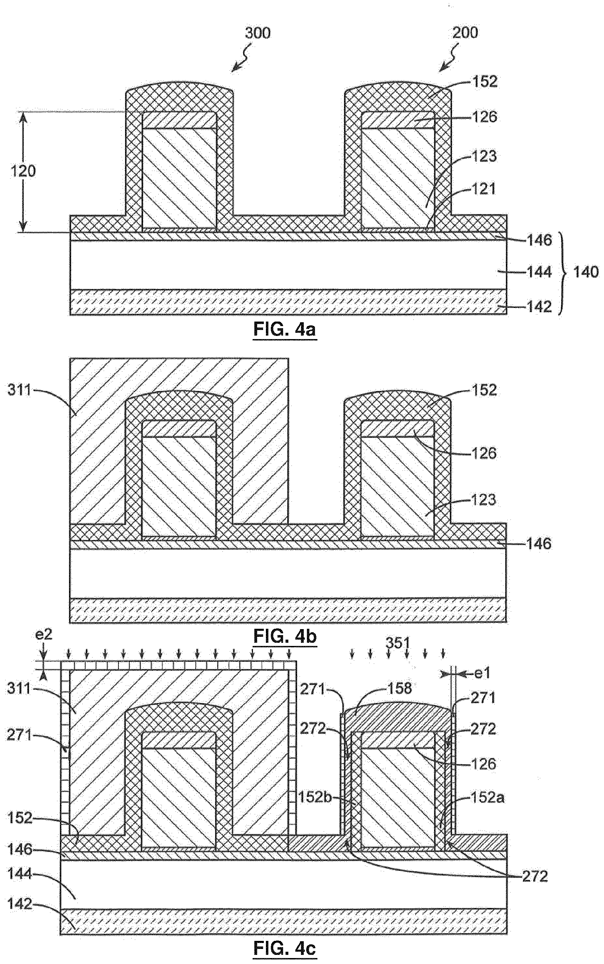

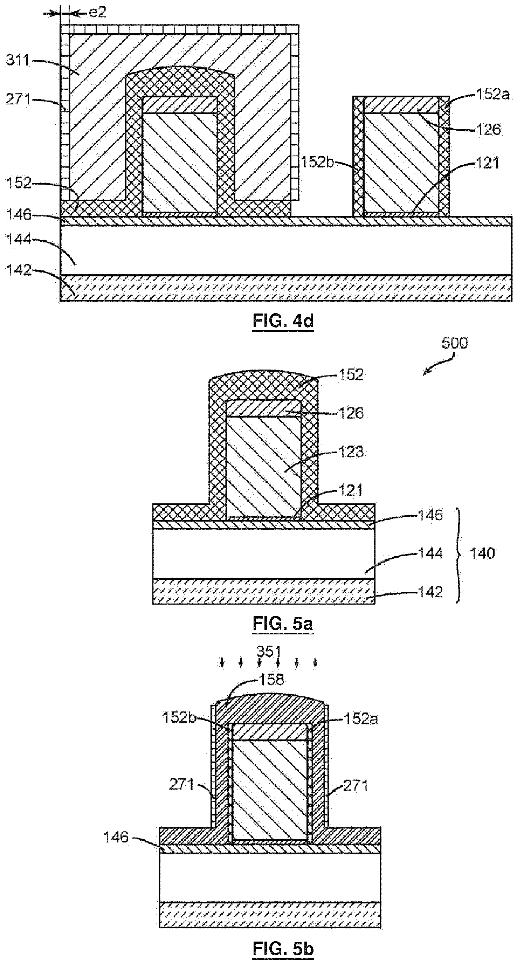

La **figure 3** résume les principales étapes 410 à 440 d'un exemple détaillé d'un procédé de formation des espaceurs d'un transistor selon l'invention. Ces étapes 410 à 440 peuvent également s'appliquer à la formation d'espaceurs sur les flancs des grilles de transistors variés : FDSOI, FinFET, etc. Les étapes 410 à 440 seront respectivement détaillées dans les paragraphes ci-dessous concernant les **figures 4a** à **4d** **et** **5a** à **5e** illustrant respectivement une structure d'un transistor 200 obtenue à l'issue d'une des étapes 410 à 440 selon un mode de réalisation de l'invention.

La **figure 4a** illustre une structure obtenue à l'issue de l'étape de formation 410 d'une couche de protection 152 recouvrant un transistor 200 formé sur un substrat 140 de type SOI comprennent une couche active 146 surmontée d'une grille 120 du transistor 200.

La formation du transistor 200 consiste à réaliser un substrat élaboré 140 de type SOI, à partir d'un substrat 142, souvent désigné substrat massif (bulk substrat en anglais), une couche isolante initiale 144 et la couche active 146, cette dernière étant destinée à former ultérieurement un canal de conduction du transistor 200.

Alternativement, le matériau semi-conducteur est pris parmi: le germanium (Ge), le silicium germanium (SiGe).

En plus d'une couche de silicium polycristallin 123 on retrouve dans un empilement des couches formant la grille 120 tout d'abord une mince couche isolante d'oxyde de grille 121 à travers laquelle un champ électrique va pouvoir se développer pour créer un canal de conduction sous-jacent entre source et drain quand une tension électrique suffisante est appliquée sur la grille 120.

Dans les transistors MOSFET les plus récents il est mis en oeuvre une technologie qualifiée du vocable anglais de « high-k/metal gate » c'est-à-dire que la couche diélectrique 121 est faite d'un matériau isolant à haute permittivité (high-k) couverte par une couche métallique (metal gate ; non illustrée en figures) de la grille 120. À ce stade, l'empilement de couches de la grille 120 comprend aussi un masque dur 126 de protection qui sera enlevé ultérieurement pour permettre la reprise de contact sur cette électrode. Ce masque dur 126, qui reste en place après gravure de la grille, est typiquement fait d'oxyde de silicium (SiO2). Son rôle est de protéger le sommet de la grille 120 de tout dommage lors de la réalisation des étapes suivantes et notamment celles de gravure des espaceurs.

De préférence, la couche diélectrique 121 est disposée au contact de la couche active 146 formant le canal de conduction. De préférence, la couche métallique est disposée au contact de la couche diélectrique 121. De préférence, la couche de silicium polycristallin 123 est disposée directement au contact de l'oxyde de grille formée par la couche diélectrique 121 si la couche métallique est absente ou est disposée directement au contact de la couche métallique.

De manière préférentielle mais non limitative, une structure 300 distincte du transistor 200 est formée, préalablement à l'étape de formation 410 de la couche de protection 152, sur le substrat 140 sur lequel repose la grille 120.

Dans le cadre de l'invention, la présence de cette structure 300 est facultative.

Dans cet exemple, et sans que cela ne soit limitatif, le transistor 200 est un transistor NMOS et la structure 300 est un transistor PMOS. Dans un autre mode de réalisation, le transistor 200 est un transistor PMOS et la structure 300 est un transistor NMOS.

L'étape de formation 410 de la couche de protection 152, d'épaisseur préférentiellement sensiblement constante, est effectuée de manière à recouvrir le transistor 200 et la structure 300, c'est-à-dire sur toutes les surfaces, verticales et horizontales, des dispositifs en cours de fabrication. Il s'agit ainsi d'un dépôt que l'on peut qualifier de conforme. De manière préférentielle mais non limitative, la couche de protection 152 est disposée directement au contact des surfaces des structures en cours de fabrication.

Cette étape de formation 410, se fait de préférence mais non limitativement à l'aide d'une méthode de dépôt dite LPCVD, acronyme de l'anglais « low pressure chemical vapor déposition », c'est-à-dire « dépôt chimique en phase vapeur à faible pression ». Ce type de dépôt qui se pratique à pression atmosphérique permet en effet un dépôt uniforme sur toutes les surfaces quelle que soit leur orientation.

Cette couche de protection 152 peut être à base de nitrure (N) et/ou de silicium (Si) et/ou de carbone (C). Elle présente une constante diélectrique égale ou inférieure à 7.

La couche de protection 152 est par exemple une couche de nitrure de silicium (SiN) dont la constante diélectrique est égale à 8 et de préférence à 7.

De manière avantageuse et non limitative, la couche de protection 152 comprend un matériau présentant une faible constante diélectrique inférieure à 4 et de préférence inférieure à 3.1 et de préférence inférieure ou égale à 2. Par exemple, les matériaux tels que le SiCO, le SiC, le SiCN, le SiOCN, le SiCBN, le SiOCH, le c-BN, le nitrure de bore (BN) et le SiO2, sont qualifiés de matériaux « low-k », c'est-à-dire à faible constante de diélectrique. Le matériau de la couche de protection 152 pris parmi les matériaux « low-k » tels que ci-dessus permet ainsi de réduire la capacité parasite pour améliorer la performance du transistor.

L'invention n'est néanmoins pas limitée aux exemples de matériaux tels que ci-dessus. La couche de protection 152 peut être d'un autre matériau présentant une faible constante diélectrique inférieure ou égale à 8 et de préférence à 7.

Dans un mode de réalisation avantageux, la couche de protection 152 est une couche poreuse. Alternativement, la couche de protection 152 est une couche non-poreuse.

De préférence, le matériau de la couche de protection 152 est compatible avec un nettoyage par voie sèche ou humide réalisé à une étape suivante 440 pour enlever une couche de protection modifiée 158 (décrite ultérieurement).

L'épaisseur de la couche de protection 152 est de préférence suffisamment importante, pour que après la réalisation des étapes de modification 430 et de retrait 440, il reste des portions non-modifiées 152a, 152b de la couche de protection 152 au niveau des flancs de la grille 120.

Dans un mode de réalisation préféré, l'épaisseur de la couche de protection 152 est comprise entre 5 nm et 30 nm, de préférence 10 nm.

De manière préférentielle mais uniquement facultative, le procédé de l'invention comprend une étape facultative de réduction de la constante diélectrique de la couche de protection 152. Selon un mode de réalisation avantageux, la réduction de la constante diélectrique est obtenue lors de l'étape de dépôt de la couche de protection 152.

Selon un mode de réalisation, la réduction de la constante diélectrique comprend l'introduction dans la couche de protection 152 en formation de précurseurs qui forment des liaisons réduisant la polarisabilité de la couche 152. Ces précurseurs sont choisis de manière à générer des liaisons moins polaires que le nitrure de silicium, telles que le Si-F, le SiOF, le Si-O, le C-C, le C-H, et le Si-CH3.

Selon un autre mode de réalisation, alternatif ou combinable au précédent, la réduction de la constante diélectrique comprend l'introduction dans la couche de protection 152 en formation d'une porosité.

La **figure 4b** illustre la structure du transistor 200 à l'issue d'une étape facultative de dépôt 310 d'une couche 311 comprenant du carbone, cette couche 311 comprenant du carbone étant distincte dudit transistor 200.

Dans un mode de réalisation préférentiel, la couche 311 comprenant du carbone est configurée pour recouvrir la structure 300 distincte dudit transistor 200, la structure 300 et ledit transistor 200 étant sur le même substrat 140. Cette couche 311 comprenant du carbone peut faire office de protection pour la structure qu'elle recouvre.

De préférence, la couche 311 comprenant du carbone est une couche de résine photosensible ou thermosensible. Dans un autre mode de réalisation, la couche 311 comprenant du carbone est un masque dur comprenant du carbone et de préférence formé de carbone.

La **figure 4c** illustre la structure du transistor 200 à l'issue de l'étape de modification 430 de la couche de protection 152 et de formation d'un film carboné 271.

L'étape de la modification 430 de la couche de protection 152 telle que formée à l'issue de l'étape 410, se fait par mise en présence de la couche de protection 152 avec un plasma comprenant des ions plus lourds que l'hydrogène et du CxHy où x est la proportion de carbone et y est la proportion d'hydrogène et d'ions plus lourds que l'hydrogène, afin de former une couche de protection modifiée 158 et un film carboné 271.

Ainsi, les espèces du plasma remplissent trois fonctions au moins. Ces trois fonctions seront expliquées en détail dans la description ci-dessous.
« a » dépôt d'une couche protectrice formée du film carboné 271, sur les flancs de la grille 120 et sur la couche 311 comprenant du carbone lorsqu'elle est présente ;
« b » empêcher la formation du film carboné 271 sur les surfaces perpendiculaires aux flancs de la grille 120 ;
« c » modification de la couche de protection 152 dans toute son épaisseur ou sur une épaisseur importante sur les surfaces perpendiculaires aux flancs de la grille 120 et modification de la couche de protection 152 dans une moindre épaisseur sur les flancs de la grille 120. De préférence, la couche de protection 152 située sur le sommet de la grille 120 et de part et d'autre de la grille 120 est entièrement modifiée alors que la couche de protection 152 située sur les flancs de la grille 120 est non modifiée ou modifiée sur plus une faible épaisseur.

Du CxHy est introduit dans le plasma, par exemple du méthane (CH4) afin de réaliser les fonctions « a » et « c ». Les espèces chimiques du plasma contenant du carbone provenant du CH4 ou plus généralement du CxHy assurent la fonction « a ». Pour remplir la fonction « b », le plasma comprend des ions plus lourds que l'hydrogène tels que l'hélium (He), l'argon (Ar), l'azote (N2), le xénon (Xe) et l'oxygène (O2). Par souci de concision, ces ions sont désignés dans la suite de la description « ions lourds ».

La fonction « c » est assurée par des ions à base d'hydrogène. Les ions à base d'hydrogène sont de préférence pris parmi : H, H⁺, H₂⁺, H₃⁺. Dans la suite de la description, et par souci de concision, on désignera les ions à base d'hydrogène « ions hydrogène ». Ces ions ont pour propriété de pénétrer facilement et en profondeur dans la couche de protection 152. Ils modifient ainsi la couche de protection 152 mais sans la pulvériser. Les ions lourds pénètrent beaucoup moins profondément dans la couche de protection 152. Ces ions lourds restent localisés en surface et ne sont donc pas aptes à modifier une épaisseur importante, et a fortiori toute l'épaisseur, de la couche de protection 152. La profondeur de pénétration des ions lourds est environs dix fois plus faible que la profondeur de pénétration des ions hydrogène.

Plus précisément, les ions à base d'hydrogène peuvent être implantés dans le matériau à graver, sans provoquer de dislocation de sa structure atomique telle qu'elle entraînerait une pulvérisation de ce dernier, et donc sans redépôt du matériau gravé sur les parois du réacteur ou les motifs en cours de gravure eux-mêmes, sont susceptibles de convenir.

Une fonction additionnelle est assurée par les ions lourds. Cette fonction additionnelle consiste à dissocier la molécule CxHy afin de libérer l'espèce H. L'hélium (He) est particulièrement efficace pour assurer cette fonction. Le mélange introduit dans le réacteur plasma comprend ainsi de préférence un mélange CxHy/He.

On notera ici que cette étape de modification 430 de la couche à graver peut se pratiquer de nombreuses façons différentes en adaptant toutes sortes de moyens couramment employés par l'industrie de la microélectronique. On utilise notamment des gravures standard dont lesquels on peut développer des plasmas à faible ou haute densité et où on peut contrôler l'énergie des ions pour permettre l'implantation des espèces légères ci-dessus destinées à modifier la couche à graver. On peut aussi utiliser un type de plasma dit par immersion couramment utilisé pour pratiquer une implantation d'espèces en surface d'un dispositif en cours de fabrication.

Une modification de la couche effectuée par une implantation à l'aide d'un plasma a pour avantage de permettre une implantation en continue depuis la surface libre de la couche de protection 152 et sur une épaisseur faible, typiquement comprise entre 0 et 100 nm voire entre 0 et 30 nm. Elle permet également de bénéficier d'une sélectivité améliorée dès le début de la gravure et d'une vitesse de gravure constante, conduisant à une précision de gravure améliorée.

L'emploi d'un plasma pour implanter la couche de protection 152 permet ainsi de retirer une couche très fine, typiquement comprise entre 1 et 10 nm et plus généralement entre 1 et 30 nm.

Cette étape de la modification 430 est réalisée pour que le plasma soit anisotrope de manière à bombarder les ions dans une direction 351 privilégiée parallèle aux flancs de la grille 120. Le plasma utilisé lors de cette étape 430 crée un bombardement d'ions à base d'hydrogène (H) provenant de la molécule du CxHy et s'implantant dans une portion supérieure de l'épaisseur de la couche de protection 152 au niveau des flancs de la grille 120. Ces ions à base d'hydrogène proviennent du CxHy dont la molécule est dissociée par les ions plus lourds que l'hydrogène du plasma.

Ainsi les ions modifient les surfaces perpendiculaires à la direction du bombardement sur une épaisseur plus importante que les surfaces parallèles à la direction du bombardement. Ainsi la portion supérieure de l'épaisseur de la couche de protection 152 au niveau des flancs de la grille 120 est modifiée sur une épaisseur moindre que la surface au sommet de la grille 120 et les surfaces de la couche de protection 152 recouvrant la couche active 146. Une épaisseur non modifiée 152a, 152b de la couche de protection 152 recouvrant les flancs de la grille 120 est conservée et deviendra des espaceurs 152a, 152b.

Ainsi les ions à base d'hydrogène pénètrent dans la couche de protection 152 pour la modifier. Dans le même temps, le CxHy, de préférence du CH4, du plasma tend à déposer un film carboné 271 sur les différentes parois.

Le bombardement d'ions plus lourds que l'hydrogène permet aux espèces carbonées provenant du CxHy de former le film carboné 271, notamment sur des surfaces parallèles à la direction du bombardement, tout en empêchant de former un film carboné 271 sur les surfaces de la couche de protection 152 qui sont perpendiculaires à la direction 351 du bombardement, tel que le fond des tranchées. En effet, les ions lourds du plasma pulvérisent les espèces carbonées provenant du CxHy qui aurait tendance à se former sur ces parois perpendiculaires à la direction d'implantation et empêchent donc la croissance de ce film carboné 271 sur ces parois perpendiculaires à la direction d'implantation.

En revanche, sur les surfaces qui reçoivent un bombardement moindre ou qui ne reçoivent pas de bombardement, ce film carboné 271 se forme. Ainsi, il se forme notamment sur les surfaces parallèles à la direction 351 du bombardement.

On notera que de manière particulièrement avantageuse, le film carboné 271 agit comme une couche de protection carbonée pour la couche de protection 152 qu'il recouvre, réduisant l'épaisseur sur laquelle les ions hydrogène pénètrent dans la couche de protection 152 et modifie cette dernière. Ainsi, le film carboné 271 permet d'augmenter la différence d'épaisseur de modification entre les surfaces recouvertes par le film carboné 271 et les surfaces qui ne le sont pas. On contrôle ainsi encore mieux l'épaisseur gravée.

Lors de ladite étape de modification de la couche à graver, la concentration en CxHy dans le plasma est de préférence, comprise entre 2% et 50% du débit total et de préférence entre 8% et 40%. Au-delà on sera en mode dépôt. La dilution dépendra du choix des espèces des ions lourds du plasma, He, N2, Ar ou O2 etc. Par exemple :
- pour He ou Ar il faut que le débit de CxHy soit inférieur à 10% du débit total ;
- pour N2 il faut que le débit de CxHy soit inférieur à 20% du débit total ;
- pour 02 il faut que le débit de CxHy soit inférieur à 50% du débit total.

Lors de ladite étape de modification de la couche à graver, la concentration en ions plus lourds que l'hydrogène dans le plasma est comprise entre 50% et 98% et de préférence entre 55% et 85% et de 60% et 80%. Ces concentrations se mesurent habituellement par un ratio entre les deux composants gazeux.

Dans la présente demande de brevet un ratio entre deux composants gazeux est un ratio portant sur les débits respectifs d'introduction des composants dans le réacteur plasma. Chaque débit se mesure habituellement en sccm. Typiquement un débit se mesure avec un débitmètre associé au réacteur.

Dans un mode de réalisation (tel qu'illustré précédemment) utilisant un plasma de He/CH4 de préférence sous forme de mélange, la couche de protection 152 est modifiée par les ions H venant du gaz de CH4. Les ions He détruisent ou empêchent la formation du film carboné 271 qui aurait tendance à se former sur les surfaces perpendiculaires à la direction 351 telles que les surfaces de la couche de protection modifiée 158 recouvrant la couche active 146 et le masque dur 126 au sommet de la grille 120.

Dans un autre mode de réalisation utilisant un plasma de H2/CH4/Ar, en plus des ions hydrogène, la nature des ions Argon et les paramètres du plasma, en particulier son énergie, permettent d'assurer une déplétion des groupements méthyles du film carboné 271 réalisée de manière anisotrope, de sorte que le film carboné 271 n'est pas formé sur les surfaces perpendiculaires à la direction 351 telles que ci-dessus.

Ainsi, l'argon permet d'empêcher, éventuellement à lui seul, également la formation du film carboné sur les surfaces perpendiculaires à la direction 351 de bombardement. Combiné à He, N2, Xe et/ou O2 il contribue à pulvériser le film carboné 271 qui aurait tendance à se former.

Ainsi, les ions lourds Ar, He, N2, Xe ou O2 permettent de renforcer l'action des ions à base d'hydrogène en empêchant également la formation du film carboné 271 sur les surfaces perpendiculaires à la direction principale 351 du bombardement.

On notera que dans tous ces modes de réalisation, les ions H du CH4 participent en synergie avec les ions lourds du plasma (He, Ar, N2, Xe ou O2 par exemple) à la modification de la portion 158 de la couche de protection 152, même si la profondeur de pénétration de ces ions lourds est plus faible que celle des ions à base d'hydrogène.

Ainsi, à l'issue de cette étape de modification 430, le film carboné 271 formé recouvre seulement les surfaces de la couche de protection 152 qui sont perpendiculaires ou fortement inclinées par rapport au plan du substrat 140, telles que les surfaces supérieures de la couche de protection modifiée 158 au niveau des flancs de la grille 120 et les parois ou flancs de la couche 311 comprenant du carbone.

On notera que de manière inattendue, le film carboné 271 se forme sur les parois de la couche 311 comprenant du carbone. Les ions du plasma ne pulvérisent pas le film carboné 271 formé sur les parois de la couche 311 comprenant du carbone. Il est probable que cela soit dû aux affinités chimiques et réactions moléculaires entre le carbone de la couche 311 et les espèces chimiques contenant du carbone provenant du CxHy. Cette affinité accélère l'obtention d'un régime de dépôt et favorise la formation du film carboné 271 sur la couche 311 comprenant du carbone. Le film carboné 271 se forme donc rapidement et en dépit du bombardement des ions lourds. Ce film carboné 271 agit ainsi comme une couche de protection pour la couche 311 comprenant du carbone et empêche cette dernière d'être dégradée par le bombardement ionique. Les dimensions de la couche 311 sont donc conservées malgré le bombardement ionique.

En raison des réactions moléculaires ci-dessus, l'épaisseur e2 du film carboné 271 recouvrant les parois de la couche 311 comprenant du carbone est supérieure à l'épaisseur e1 du film carboné 271 sur la couche de protection 152 (au niveau des flancs de la grille 120). De manière encore plus avantageuse, l'épaisseur e2 du film carboné 271 est au moins deux fois supérieure à l'épaisseur e1 du film carboné 271. Les épaisseurs e1 et e2 apparaissent sur la **figure 4c****.**

L'épaisseur e1 du film carboné 271, mesurée sur un flanc de la grille 120 et perpendiculairement au flanc, est de préférence très fin, par exemple compris entre 1 et 5 nm, de préférence 1 nm.

L'épaisseur e2 du film carboné 271, mesurée sur la couche 311 comprenant du carbone et parallèlement à la direction d'implantation, est de par exemple 5 nm ou compris entre 1 et 10 nm.

Le film carboné 271 formé sur la couche 311 comportant du carbone est ainsi plus épais que celui sur la couche de protection 152 du fait des réactions chimiques entre le carbone de la couche 311 et le carbone apporté par le CxHy du plasma.

L'épaisseur e2 du film carboné 271 formé sur la couche 311 comportant du carbone lui permet de résister au bombardement des ions réalisé de manière anisotrope comme ci-dessus. Ainsi, et de manière surprenante, ce film carboné 271 renforcé ou sur épaissi permet de protéger la couche 311 comprenant du carbone lors de l'étape de modification 430 ainsi que lors de l'étape de retrait 440 et cela même sur les surfaces perpendiculaires à la direction 351 du bombardement.

Ainsi, le film carboné 271 agit comme une couche de protection pour la couche 311 comprenant du carbone, empêchant ou réduisant la modification de cette dernière sous l'effet du bombardement ionique.

On notera ici que l'étape de modification 430 peut se pratiquer de nombreuses façons différentes en adaptant toutes sortes de moyens couramment employés par l'industrie de la microélectronique, tel qu'à l'aide de tout type graveur, par exemple dans un réacteur ICP de l'anglais « Inductively Coupled Plasma » c'est-à-dire « plasma à couplage inductif », ou dans un réacteur de type CCP de l'anglais « Capacitive Coupled Plasma » c'est-à-dire « plasma à couplage capacitif » qui permet de contrôler l'énergie des ions. On peut aussi utiliser un type de plasma dit par immersion couramment utilisé pour pratiquer une implantation d'espèces en surface d'un dispositif en cours de fabrication.

Pour choisir les paramètres d'implantation l'homme du métier, afin de déterminer le comportement du matériau à graver dans le type d'implanteur choisi, procédera préalablement de préférence à des essais « pleine plaque » afin d'établir des courbes de comportement. Il en déduira les paramètres de l'implantation, en particulier l'énergie et la dose d'ions, c'est-à-dire le temps d'exposition, à utiliser pour atteindre l'épaisseur voulue de matériau à modifier.

A titre d'exemple, le tableau ci-après donne des conditions typiques de mise en oeuvre de l'étape de modification 430 de la couche de protection 152, réalisé par utilisation d'un plasma de He/CH4, de H2/CH4/Ar, de CH4/Ar, de CH4/N2, ou de CH4/N2/H2, en fonction du temps en secondes et la puissance de la polarisation (bias) en watts, etc. Ces conditions sont largement dépendantes de l'épaisseur à modifier de la couche de protection 152.

Dans l'exemple ci-dessous, la couche de protection 152 est une couche à base de nitrure telle qu'une couche de nitrure de silicium.

| | |
|---|---|
| Réacteur de gravure : | réacteur ICP ou CCP ou par immersion plasma de He/CH4 (He : 50 - 500 sccm, CH4 : 5 - 15 sccm), ou plasma de H2/CH4/Ar ou de H2/CH4/N2 (H2 : 50 - 500 sccm, CH4 : 5 - 15 sccm, Ar (Argon) ou N2 : 100 - 1000 sccm) |
| Épaisseur de la couche de protection 152 à modifier (épaisseur de la couche de protection modifiée 158) : | 1 - quelques dix nm, par exemple 6-10nm |
| Puissance de la source : | 0 - 2000 Watts |
| Puissance de polarisation (énergie des ions) : | 20 - 500 V |
| Pression : | 5 milli Torr - 10 milli Torr |
| Température : | 10 - 100 °C |
| Temps : | quelques secondes à quelques centaines de secondes |

Un exemple plus précis de mise en oeuvre de l'étape de modification 430 permettant de modifier une épaisseur de 17 nm de nitrure, réalisé par utilisation d'un plasma de He/CH4, est décrit dans le tableau ci-dessous :

| | |
|---|---|
| Réacteur de gravure : | plasma de He/CH4 (He : 250 sccm, CH4 : 10 sccm) |
| Épaisseur de la couche à base de nitrure 152 à modifier (épaisseur de la couche modifiée 158 à base de nitrure) : | 17 nm |
| Puissance de la source : | 500 W |
| Puissance de polarisation (énergie des ions) : | 250 V |
| Pression : | 10 milli Torr |
| Température : | 60°C |
| Temps : | 60 secondes |

Un autre exemple plus précis de mise en oeuvre de l'étape de modification 430 permettant de modifier une épaisseur de 15 nm de SiCBO par utilisation d'un plasma de He/CH4, est décrit dans le tableau ci-dessous:

| | |
|---|---|
| Réacteur de gravure : | plasma de He/CH4 (He : 250 sccm, CH4 : 10 sccm) |
| Épaisseur de la couche de protection 152 à modifier (SiCBO): | 15 nm |
| Puissance de la source : | 500 W |
| Puissance de polarisation (énergie des ions) : | 250 V |
| Pression: | 10 milli Torr |
| Température : | 60°C |
| Temps : | 60 secondes |

Préférentiellement, la couche de protection 152 est modifiée sur toute son épaisseur au-dessus de la grille 120 et au-dessus de la couche active 146 et tout en laissant en place des portions non-modifiées 152a, 152b de la couche de protection 152 au niveau des flancs de la grille 120.

La **figure 4d** illustre le résultat de l'étape de retrait 440 de la couche de protection modifiée 158 après que l'on ait procédé à une opération de gravure sélective de la couche de protection modifiée 158 par rapport : au film carboné 271, aux portions non-modifiées 152a, 152b de la couche de protection 152 et à la couche active 146.

La solution de gravure grave ainsi la couche de protection modifiée 158 à laquelle elle a directement accès sur le sommet de la grille 120 et dans le fond des tranchées.

Dans le cas où les ions à base d'hydrogène se sont implantés dans la couche de protection située sur les flancs de la grille, ce qui peut être le cas si le film carboné 271 est fin, une épaisseur de la couche de protection située sur les flancs de la grille est alors modifiée.

Lors de l'étape de retrait, la solution de gravure peut s'introduire également dans l'espace situé au niveau des flancs de la grille 120, entre le film carboné 271 recouvrant les flancs et les portions non-modifiées 152a, 152b. Dans cet espace, occupé par la couche de protection modifiée 158 obtenue en fin d'étape de modification 430, la solution de gravure consomme la couche de protection modifiée 158. Les passages empruntés par la solution de gravure pour consommer cette portion de la couche de protection modifiée 158 sont référencés 272 sur la **figure 4c****.**

Dans ce cas, le film carboné 271 n'est plus soutenu et disparaît. Typiquement cette désagrégation du film carboné est qualifié de « lift off », soit de retrait par soulèvement.

Alternativement, dans le cas où les ions à base d'hydrogène ne se sont pas implantés dans la couche de protection située sur les flancs de la grille, ce qui peut être le cas si le film carboné 271 est suffisamment épais, la couche de protection située sur les flancs de la grille n'est pas modifiée ou que très peu modifiée. Lors de l'étape de retrait, la solution de gravure ne retire donc pas la couche de protection 152 située sur les flancs. Le film carboné 271 reste donc maintenu par cette dernière. Il ne disparait alors pas lors de l'étape de retrait. Ce mode de réalisation n'est pas illustré sur les figures.

Avantageusement, le film carboné 271 d'épaisseur e2 protège la couche 311 comprenant du carbone lors de cette étape de retrait 440.

De plus, la solution de gravure ne consomme avantageusement pas ou que peu de la couche 311 comprenant du carbone. La réalisation de l'étape de retrait 440 ne conduit donc pas à une consommation de la couche 311 comprenant du carbone.

Avantageusement, les paramètres de l'étape de retrait sont également réglés de manière à ce que la couche de protection modifiée 158 puisse être gravée sélectivement par rapport à une couche faite d'un oxyde typiquement un oxyde dudit matériau semi-conducteur, cette dernière formant par exemple une couche d'oxyde de grille. Typiquement, la gravure sélective de la couche de protection modifiée 158 ne consomme pas l'oxyde de silicium SiO2.

Avantageusement, ces paramètres sont également réglés de manière à ce que la couche de protection modifiée 158 puisse être gravée sélectivement par rapport au matériau semi-conducteur de la couche active 146.

De manière préférentielle, l'étape de retrait 440 est effectuée par gravure humide en utilisant une solution de gravure à base d'acide fluorhydrique (HF).

Dans un mode de réalisation dans lequel la couche de protection modifiée 158 est typiquement une couche à base de nitrure, l'étape de retrait 440 peut être effectuée par gravure humide en utilisant une solution de gravure à base d'acide fluorhydrique (HF) ou d'acide phosphorique (H3PO4) pour le SiC, SiCN ou le SiN.

Pour éviter les problèmes des procédés conventionnels de gravure des espaceurs décrits dans les **figures 2a à 2c****,** il est nécessaire que la gravure de la couche de protection modifiée 158 soit la plus sélective possible par rapport au silicium notamment afin de ne pas attaquer le silicium de la couche active 146. Par exemple, dans ce mode de réalisation de gravure humide, il n'y a aucune consommation de silicium de la couche active 146 due à l'utilisation de la solution gravure à base d'acide fluorhydrique (HF).

Comme mentionné ci-dessus, l'épaisseur de la couche de protection modifiée 158 est typiquement comprise dans une gamme de valeurs allant de 1 nm à quelques dizaines de nm. Les temps de gravure peuvent aller de quelques secondes à quelques minutes en étant évidemment directement dépendants de l'épaisseur qui a été modifiée.

À titre d'exemple, pour enlever une épaisseur modifiée comprise entre 5 nm et 20 nm de nitrure modifié il faut de l'ordre de 30 secondes avec une solution d'acide fluorhydrique (HF) à 1%. Le même temps de gravure est obtenu avec de l'acide phosphorique dilué (H3PO4) à 85% pour graver une couche de nitrure de silicium (SiN) ou de SiC.

Une solution d'acide fluorhydrique (HF) peut être utilisée pour des couches de protection à base d'autres matériaux que le nitrure, le silicium et le carbone.

Par exemple, pour enlever une épaisseur modifiée de 15 nm de SiCBO modifié il faut de l'ordre de 30 secondes avec une solution d'acide fluorhydrique (HF) à 1%.

L'arrêt de ladite gravure sélective peut donc se faire sur les portions non-modifiées 152a, 152b de la couche de protection 152 ou/et sur le silicium monocristallin de la couche active 146 ou/et encore sur le masque dur 126 au sommet de la grille 120, jusqu'à la disparition de la couche de protection modifiée 158.

Pour le retrait de la couche de protection modifiée 158, on a de préférence recourt à une gravure humide qui combine le retrait de la couche de protection modifiée 158 avec un nettoyage humide de la tranche contenant les dispositifs en cours de fabrication, car après cette gravure humide, conventionnellement un nettoyage humide (traduction de l'anglais « wet clean ») est réalisé pour nettoyer un wafer sur lequel est le transistor 200.

De préférence, cette gravure humide est combinée avec le nettoyage humide, ce qui simplifie le procédé et apporte un gain de temps.

Les paramètres du nettoyage humide sont également réglés de manière à ce que la couche de protection modifiée 158 puisse être gravée très sélectivement par rapport aux espèces contenant du carbone du film carboné 271 notamment recouvrant des parois de la couche 311 comprenant le carbone, et aux portions non-modifiées (les espaceurs obtenus) 152a, 152b de la couche de protection 152.

Alternativement à une gravure humide, une gravure sèche de la couche de protection modifiée 158 sélectivement au silicium de la couche active 146, au matériau des espaceurs 152a, 152b, à l'oxyde de silicium (SiO2) du masque dur 126 pourra alors être aussi pratiquée pour cette étape de retrait 440 par voie sèche de la couche de protection modifiée 158.

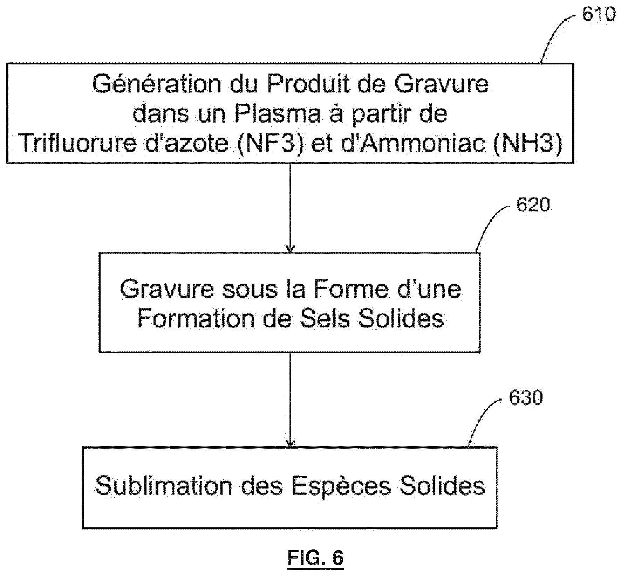

Le principe du retrait par voie sèche de la couche de protection modifiée 158 typiquement une couche modifiée 158 à base de nitrure comprend les étapes suivantes 610 à 630 illustrées en **figure 6** qui s'effectuent dans une chambre de réaction où l'on forme un plasma. Les épaisseurs traitées sont typiquement comprises entre 1 nm et quelques dizaines de nanomètres.

La méthode est celle décrite par H. Nishini et ses coauteurs dans une publication en anglais intitulée « Damage-free selective etching of Si native oxides using NH3/NF3 and SF6/H2O down flow etching » parue dans le « Journal of Applied Physics » volume 74 (2), en juillet 1993.

Le principe du retrait par voie sèche de la couche de protection modifiée 158 est proche de celui décrit dans la publication ci-dessus. La différence est que dans le cas de l'invention on ne grave pas de l'oxyde de silicium mais la couche de protection modifiée 158 par utilisation d'un plasma de type par exemple H2/CH4/Ar.

Le mécanisme est toutefois le même et comprend les étapes suivantes qui s'effectuent dans une chambre de réaction où l'on forme un plasma. Une première étape 610 consiste à générer le produit de gravure dans le plasma selon la réaction chimique suivante :

NF₃+NH₃ → NH₄F + NH₄F.HF

qui fait réagir du trifluorure d'azote (NF₃) avec de l'ammoniac (NH₃).

La gravure se fait au cours d'une deuxième étape 620, à une température de l'ordre de 30°C et plus généralement entre 10°C et 50°C, sous la forme d'une formation de sels selon la réaction chimique suivante :

NH₄F or NH₄F.HF + SiNH → (NH₄)2SiF₆ (solide) + H₂

Au cours d'une opération qui dure entre quelques secondes et quelques minutes et qui s'effectue sous une pression comprise entre quelques milli Torr et quelques Torr. Plus précisément, cette opération dure entre 20 secondes et 2 minutes et s'effectue sous une pression comprise entre 500 milli Torr et 3 Torrs.

Les espèces solides qui sont formées au cours de cette opération sont ensuite sublimées 630 à une température supérieure à 100°C pendant quelques dizaines de secondes selon la réaction suivante :

(NH₄)2SiF₆ (solid) → SiF₄(g) + NH₃(g) + HF(g)

Par exemple, pour enlever une couche de 10 nm de nitrure modifié 158 les flux de trifluorure d'azote (NF₃) et d'ammoniac (NH₃) sont respectivement de 50 sccm et de 300 sccm à 30°C pendant 45 secondes pour l'étape 620 de formation des sels qui est suivie par l'étape de sublimation 630 qui s'effectue à 180°C pendant 60 secondes.

Ce mode de réalisation permet d'obtenir une très bonne sélectivité de la gravure du couche de protection modifiée 158 par rapport aux portions non-modifiées 152a, 152b et au matériau semi-conducteur non modifié. En particulier, cette sélectivité de la gravure est très supérieure (typiquement un facteur 10 au moins) à celle obtenue avec une solution de HF.

À l'issue de l'étape de retrait 440, il ne reste donc que les portions non-modifiées 152a, 152b de la couche initiale de protection 152 essentiellement sur les flancs de l'empilement de couches qui forment la grille 120. Ces portions non-modifiées 152a, 152b constituent les espaceurs 152a, 152b pour la grille 120 du transistor 200 par exemple de de type FDSOI. De plus, la gravure de la couche de protection modifiée 158 peut être également réalisée pour la réalisation des espaceurs d'un transistor tridimensionnel de type FinFET sans que cette application soit limitative de l'invention.

Le résultat de la **figure 4d** peut être le résultat d'une seule étape de modification et d'une seule étape de retrait ou d'une pluralité de séquence comprenant ces étapes. En effet, les opérations de modification 430 de la couche de protection 152 et de retrait 440 de la couche de protection modifiée 158 peuvent optionnellement être répétées 450. Les séquences comprenant chacune une étape de modification 430 et une étape de retrait 440 sont réalisées jusqu'à enlèvement complet de la couche de protection 158 en dehors des flancs de la grille 120. Le nombre de séquences est calculé en fonction de la vitesse de gravure de la première séquence.

Des étapes additionnelles peuvent par exemple être des étapes standard où l'on réalise possiblement les extensions des zones source/drain par implantation ionique de dopants avant croissance épitaxiale des source/drain surélevés de transistors FDSOI.

Comme mentionné ci-dessus, le mode de réalisation illustré en figures **4a** à **4d** montre la fabrication des espaceurs 152a, 152b du transistor 200 par exemple de type PMOS, sans consommer la couche 311 comprenant du carbone recouvrant la structure 300 tel qu'un transistor de type NMOS, afin d'empêcher la couche 311 comprenant du carbone d'être endommagée par la réalisation des étapes de modification 430 et de retrait 440.

Le procédé de l'invention peut être appliqué pour fabriquer des dispositifs microélectroniques sur un même substrat sur lequel aucun des dispositifs en cours de fabrication n'est recouvert et protégé par une couche de protection telle que la couche 311 comprenant du carbone.

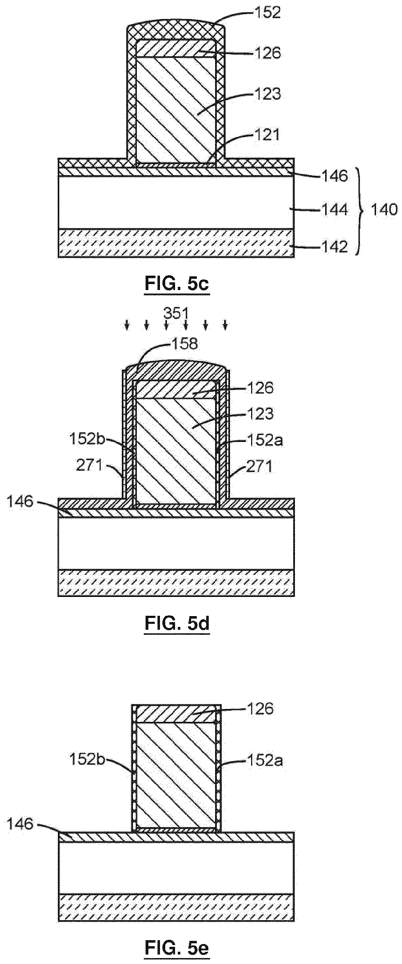

Un mode de réalisation sans dépôt d'une couche 311 comprenant du carbone est illustré en **figures 5a, 5b** et **5e****.**

La **figure 5a** illustre une structure obtenue à l'issue de l'étape de formation 410 d'une couche de protection 152 recouvrant un transistor 500 formé sur un substrat 140 de type SOI comprennent une couche active 146 surmontée d'une grille 120 du transistor 500.

La structure de départ du transistor 500 est similaire à celle du transistor 200 tel qu'illustrée en **figure 4a****.**

Cette étape de formation 410 n'est pas différente de celle illustrée précédemment en référence au mode de réalisation décrit en figures **4a** à **4d****.**

La description détaillée de la structure de départ du transistor 500 et de l'étape de formation 410 est par conséquent omise afin d'éviter une description redondante.

Dans le présent mode de réalisation, aucune étape de dépôt d'une couche comprenant du carbone (telle que la couche 311 comme décrite précédemment) n'est réalisée de manière à recouvrir une autre structure formée préalablement sur le substrat 140.

La **figure 5b** montre la structure du transistor 500 obtenue à l'issue de l'étape de modification 430 selon le présent mode de réalisation.

Selon ce mode de réalisation, l'étape de modification 430 est une unique étape effectuée de manière à modifier la couche de protection 152 dans toute son épaisseur sur toutes les surfaces parallèles au plan du substrat 140 sur lequel repose la grille 120 du transistor 500 et à ne pas modifier la couche de protection 152 dans toute son épaisseur sur les surfaces perpendiculaires à ce plan.

Le type de plasma utilisé et les conditions de réalisation de mise en oeuvre de cette étape de modification 430 sont similaires à ceux de l'étape 430 du mode de réalisation illustrée précédemment en **figures 4a** à **4d****.**

Ainsi, à l'issue de cette étape de modification 430, le film carboné 271 formé recouvre seulement les surfaces perpendiculaires au plan du substrat 140, telles que les surfaces supérieures de la couche de protection modifiée 158 au niveau des flancs de la grille 120.

Le film carboné 271 est de préférence très fin, par exemple compris entre 1 et 5 nm, de préférence 1 nm.

Comme le mode de réalisation illustré précédemment en **figures 4a à 4d****,** le film carboné 271 du présent mode de réalisation ne se forme pas sur les surfaces perpendiculaires à la direction 351 du fait du bombardement ionique d'He ou d'Ar réalisé de manière anisotrope.

La **figure 5e** montre la structure finale de l'étape de retrait 440 de la couche de protection modifiée 158 selon le présent mode de réalisation.

Cette étape de retrait 440 est effectuée pour graver la couche de protection modifiée 158 par gravure sélectivement aux portions non-modifiées 152a, 152b de la couche de protection 152, et/ou au matériau semi-conducteur de la couche active 146 et/ou à l'oxyde de silicium (SiO2) du masque dur 126 au sommet de la grille 120. Cette étape de retrait peut être combinée avec une étape standard de nettoyage pour simplifier le procédé, ce qui permet d'apporter un gain de temps.

La gravure est également sélective vis-à-vis des espèces chimiques contenant du carbone, typiquement du carbone, du film carboné 271. Néanmoins, lors de la disparition de la couche de protection modifiée 158 au niveau des flancs de la grille 120, le film carboné 271 d'épaisseur très fine (par exemple de 1 nm) se désagrège car elle n'est plus supportée.

Le type de gravure sélective et les conditions de réalisation de mise en oeuvre de cette étape de retrait 440 sont similaires à ceux de l'étape 440 du mode de réalisation illustré précédemment en **figures 4a** à **4d****.**

Un autre mode de réalisation sans dépôt d'une couche 311 comprenant du carbone est illustré en figures **5a****,** **5c** à **5e.**

Le présent mode de réalisation commence par l'étape de formation 410 d'une couche de protection 152 recouvrant un transistor 500, comme illustré précédemment en **figure 5a****.**

La **figure 5c** montre la structure du transistor 500 obtenue à l'issue d'une étape facultative de gravure anisotrope 320 de la couche de protection 152.

Optionnellement, après l'étape de formation 410 de la couche de protection 152 et préalable à l'étape de modification 430 de la couche de protection 152, on procède à une gravure anisotrope 320 de la couche de protection 152. Ceci est typiquement effectué dans un plasma de type CH3F/O2/He décrit précédemment. La gravure des espaceurs est ainsi, selon ce mode de réalisation optionnel et non limitatif, réalisée en deux étapes comprenant : une première étape dite de « gravure principale » réalisée de manière isotrope, et une seconde étape de finition généralement qualifiée de « surgravure » ou du terme anglophone de « over etching (OE) » ayant la même signification. C'est au cours de l'étape de surgravure (étapes 440) que l'on finira d'enlever la couche de protection 152 restant sur les surfaces horizontales, après avoir modifié (étape 430) la couche de protection 152 pour éviter ou limiter les problèmes décrits dans les **figures 2a** à **2c****.**

Dans le cadre de mises en oeuvre spécifiques de l'invention on peut décider de maintenir ou non l'étape de gravure anisotrope 320, les étapes suivantes s'appliquent alors soit sur la couche de protection 152 telle que déposée ou sur la couche de protection restante après qu'une gravure principale a été préalablement effectuée comme dans le procédé standard de gravure des espaceurs.

L'étape suivante à réaliser est l'étape de modification 430 de la couche de protection 152 restant à l'issue de l'étape de gravure anisotrope 320. La structure du transistor 500 à l'issue de cette étape 430 est illustrée en **figure 5d****.**

Cette étape de modification 430 n'est pas différente de celle du mode de réalisation illustré précédemment en figures **5a, 5b** et **5e** ni de celle du mode de réalisation illustré précédemment en **figures 4a** à **4d****.**

L'étape de retrait 440 de la couche de protection modifiée 158 est ensuite réalisée, comme illustré en **figure 5e****.** Cette étape de retrait 440 n'est pas différente de celle du mode de réalisation illustré précédemment en **figures 5a, 5b** et **5e** ni de celle du mode de réalisation illustré précédemment en **figures 4a** à **4d****.** Ce mode de réalisation permet d'enlever rapidement une forte épaisseur de couche de protection modifiée par la gravure isotrope puis de contrôler avec précision l'épaisseur des espaceurs en effectuant les étapes 430 et 440.

Pour certaines applications il est nécessaire d'avoir un contrôle très précis du « facettage », c'est-à-dire du problème exposé dans la figure 2c, qui résulte des opérations de gravure conventionnelle et qui peut donc peut être induit par l'étape de gravure 320 qui est comme on l'a vu optionnelle. Avantageusement, pour pallier ce problème, on évitera donc cette étape qui sera remplacée par une répétition 450 des opérations de modification 430 de la couche de protection 152 et de retrait 440 de la couche de protection modifiée 158, le retrait se faisant de préférence dans ce cas sous la forme d'un retrait par voie sèche comme décrit dans la figure 6 puisque, comme on la remarqué plus haut, les deux opérations peuvent se pratiquer dans le même réacteur de gravure.

De la description qui précède, il ressort de nombreux avantages conférés par l'invention. Le procédé de l'invention permet notamment une modification anisotrope réalisée de manière très sélective au carbone, aux portions non modifiées de la couche de protection qui constituent des espaceurs pour la grille et à un matériau semi-conducteur tel que le silicium.

Un film carboné formé lors de l'étape de modification du procédé résiste au bombardement des ions du plasma, ce qui permet de protéger la couche comprenant du carbone lors de l'étape de modification ainsi que lors de l'étape de retrait.

Le procédé de l'invention s'avère particulièrement avantageuse pour former les espaceurs de transistors de type MOSFET ou FinFET.

Le procédé de la présente invention permet de contrôler très précisément la dimension des espaceurs tout en s'affranchissant ou en réduisant les problèmes détaillés précédemment, par exemple : la consommation excessive de la couche active et/ou d'un masque de carbone ou d'une couche de résine photosensible typiquement comprenant du carbone, la formation de pieds au niveau des espaceurs de la grille à l'interface avec le substrat SOI tel que décrit en figures 2a et 2b ainsi que l'érosion des espaceurs de la grille tel que décrit en figure 2c.

L'invention n'est pas limitée aux seuls modes et exemples de réalisation décrits ci-dessus, mais s'étend à tous les modes de réalisation entrant dans la portée des revendications.

## Revendications

1. Procédé de formation d'espaceurs (152a, 152b) d'une grille (120) d'un transistor à effet de champ (200), la grille (120) comprenant un sommet et des flancs et étant située au-dessus d'une couche active (146) en un matériau semi-conducteur, **caractérisé en ce qu'**il comprend :
- au moins une étape de formation (410) d'une couche de protection (152) recouvrant la grille (120), la couche de protection (152) étant une couche à base de nitrure (N) et/ou à base de silicium (Si) et/ou à base de carbone (C) qui présente une constante diélectrique égale ou inférieure à 8 ;
- au moins une étape de modification (430) de la couche de protection (152) par mise en présence de la couche de protection (152) avec un plasma dans lequel on introduit du CxHy où x est la proportion de carbone (C) et y est la proportion d'hydrogène (H) et comprenant des ions plus lourds que l'hydrogène ; les conditions du plasma, en particulier la concentration en CxHy, l'énergie des ions plasma et la direction principale d'implantation étant choisies de manière à ce que :
o le plasma créé un bombardement d'ions à base d'hydrogène (H, H⁺, H₂⁺, H₃⁺ etc.) provenant du CxHy, le bombardement étant anisotrope selon la direction principale d'implantation qui est parallèle aux flancs de la grille (120), de sorte à former une couche de protection modifiée (158) en modifiant des portions (158) de la couche de protection (152) situées sur le sommet de la grille (120) et de part et d'autre de la grille (120) et de sorte à conserver des portions non-modifiées (152a, 152b) de la couche de protection (152) recouvrant les flancs de la grille (120),
o des espèces chimiques du plasma contenant du carbone provenant du CxHy forment un film carboné (271) notamment sur des surfaces parallèles à la direction (351) principale d'implantation ;
o le plasma créé un bombardement des ions plus lourds que l'hydrogène qui empêche audites espèces chimiques du plasma contenant du carbone et provenant du CxHy de former un film carboné (271) notamment sur les surfaces de la couche de protection (152) qui sont perpendiculaires à la direction (351) principale d'implantation ;
- au moins une étape de retrait (440) de la couche de protection modifiée (158) à l'aide d'une gravure sélective de la couche de protection modifiée (158) vis-à-vis des portions non-modifiées (152a, 152b) de la couche de protection (152).

2. Procédé selon la revendication 1 dans lequel la couche de protection (152) présente une constante diélectrique inférieure à 4 et de préférence inférieure à 3.1 et de préférence inférieure ou égale à 2.

3. Procédé selon l'une quelconque des revendications précédentes dans lequel la couche de protection (152) est une couche à base de nitrure (N) et de préférence une couche de nitrure de silicium (SiN).

4. Procédé selon l'une quelconque des revendications 1 ou 2 dans lequel la couche de protection (152) est une couche à base de silicium (Si) ou à base de carbone (C) ou dans lequel le matériau de la couche de protection (152) est pris parmi : le SiCO, le SiC, le SiCN, le SiOCN, le SiCBN, le SiOCH, le CBN, le BN, le SiCBO et le SiO2.

5. Procédé selon l'une quelconque des revendications précédentes dans lequel la couche de protection (152) est une couche poreuse.

6. Procédé selon l'une quelconque des revendications précédentes dans lequel l'étape de formation (410) de la couche de protection (152) comprend une étape de dépôt de la couche de protection (152) au cours de laquelle on effectue une étape de réduction de la constante diélectrique de la couche de protection (152) et de préférence dans lequel l'étape de réduction de la constante diélectrique de la couche de protection (152) comprend l'introduction d'une porosité dans la couche de protection (152) et/ou dans lequel l'étape de formation (410) de la couche de protection (152) comprend l'introduction de précurseurs dans la couche de protection (152) en cours de dépôt.

7. Procédé selon la revendication 1 dans lequel l'étape de formation (410) de la couche de protection (152) comprend une étape de dépôt de la couche de protection (152) au cours de laquelle on effectue une étape de réduction de la constante diélectrique de la couche de protection (152), dans lequel l'étape de formation (410) de la couche de protection (152) comprend l'introduction de précurseurs dans la couche de protection (152) en cours de dépôt, dans lequel la couche de protection est une couche à base de nitrure de silicium et dans lequel les précurseurs sont choisis de manière à former des liaisons moins polaires que le nitrure de silicium, telles que le Si-F, le SiOF, le Si-O, le C-C, le C-H, et le Si-CH3.

8. Procédé selon l'une quelconque des revendications précédentes dans lequel lors de ladite étape de modification (430) de la couche de protection (152), la concentration en CxHy dans le plasma est comprise entre 2% et 50% et de préférence entre 8% et 40% et de préférence dans lequel lors de ladite étape de modification (430) de la couche de protection (152), la concentration en ions plus lourds que l'hydrogène dans le plasma est comprise entre 50% et 98%.

9. Procédé selon l'une quelconque des revendications précédentes comprenant, préalablement à l'étape de modification (430), une étape de dépôt (310) d'une couche (311) comprenant du carbone, cette couche (311) comprenant du carbone étant distincte dudit transistor (200), et dans lequel ladite gravure est sélective de la couche de protection modifiée (158) vis-à-vis du carbone (271) et vis-à-vis des portions non-modifiées (152a, 152b) de la couche de protection (152).

10. Procédé selon la revendication précédente dans lequel la couche (311) comprenant du carbone est configurée pour recouvrir une structure (300) distincte dudit transistor (200) et dans lequel ledit transistor (200) est un transistor NMOS et ladite structure (300) est un transistor PMOS, ou dans lequel ledit transistor (200) est un transistor PMOS et ladite structure (300) est un transistor NMOS.

11. Procédé selon l'une quelconque des revendications précédentes dans lequel l'étape de modification (430) est réalisée de manière à ce que le plasma génère un bombardement des ions plus lourds que l'hydrogène de manière anisotrope selon la direction principale d'implantation parallèle aux flancs de la grille (120) de sorte à empêcher audites espèces chimiques du plasma contenant du carbone provenant du CxHy de former un film carboné (271) sur les surfaces perpendiculaires aux flancs de la grille (120).

12. Procédé selon l'une quelconque des revendications précédentes dans lequel l'étape de modification (430) est réalisée de manière à ce que les ions plus lourds que l'hydrogène du plasma dissocient la molécule du CxHy de sorte à permettre aux ions hydrogène (H) provenant du CxHy de former des ions à base d'hydrogène et de s'implanter dans lesdites portions (158) de la couche de protection (152).

13. Procédé selon l'une quelconque des revendications précédentes dans lequel lors de l'étape de modification (430) les conditions du plasma, en particulier la concentration en CxHy, l'énergie des ions et la direction principale d'implantation sont choisies de manière à ce que, au niveau des surfaces perpendiculaires à la direction principale d'implantation, tout l'épaisseur de la couche de protection (152) soit modifiée par l'implantation des ions à base d'hydrogène et dans lequel l'étape de retrait (440) est réalisée de manière à retirer toute la couche de protection modifiée (158), mettant ainsi à nu la couche active (146) au niveau des surfaces perpendiculaires à la direction principale d'implantation.

14. Procédé selon l'une quelconque des revendications précédentes dans lequel l'étape de retrait (440) de la couche de protection modifiée (158) est effectuée par gravure humide.

15. Procédé selon l'une quelconque des revendications 1 à 13 dans lequel l'étape de retrait (440) est effectuée par gravure sèche sélective de ladite couche de protection modifiée (158) vis-à-vis dudit film carboné (271), vis-à-vis des portions non-modifiées (152a, 152b) de la couche de protection (152) et vis-à-vis dudit matériau semi-conducteur, de préférence dans lequel la gravure sèche est effectuée dans un plasma formé dans une enceinte confinée à partir de trifluorure d'azote (NF3) et d'ammoniac (NH3) et de préférence dans lequel la gravure sèche comprend :
- une étape de gravure (620) consistant en la formation de sels solides ;
- une étape de sublimation (630) des espèces solides.

## Patentansprüche

1. Verfahren zum Bilden von Abstandshaltern (152a, 152b) eines Gates (120) eines Feldeffekttransistors (200), wobei das Gate (120) einen Scheitel und Flanken aufweist und sich oberhalb einer Wirkschicht (146) aus einem Halbleitermaterial befindet, **dadurch gekennzeichnet, dass** es umfasst:
- zumindest einen Schritt des Ausbildens (410) einer das Gate (120) überdeckenden Schutzschicht (152), wobei die Schutzschicht (152) eine Schicht auf Basis von Nitrid (N) und/oder auf Basis von Silicium (Si) und/oder auf Basis von Kohlenstoff (C) ist, die eine Dielektrizitätskonstante gleich oder unter 8 aufweist;
- zumindest einen Schritt des Modifizierens (430) der Schutzschicht (152) durch Inkontaktbringen der Schutzschicht (152) mit einem Plasma, in das CxHy eingebracht wird, wobei x der Anteil an Kohlenstoff (C) ist und y der Anteil an Wasserstoff (H) ist, und Ionen schwerer als Wasserstoff enthält; wobei die Plasmabedingungen, insbesondere die CxHy-Konzentration, die Energie der Plasmaionen und die Implantationshauptrichtung so gewählt sind, dass:
∘ das Plasma eine Bombardierung mit Ionen auf Basis von Wasserstoff (H, H+, H₂⁺, H3⁺, etc.) aus dem CxHy schafft, wobei die Bombardierung anisotrop in der Implantationshauptrichtung ist, die parallel zu den Flanken des Gates (120) verläuft, so dass eine modifizierte Schutzschicht (158) gebildet wird, indem die Abschnitte (158) der Schutzschicht (152), die am Scheitel des Gates (120) und beiderseits des Gates (120) liegen, modifiziert werden, und so dass nicht modifizierten Abschnitte (152a, 152b) der Schutzschicht (152) erhalten bleiben, die die Flanken des Gates (120) überdecken,
∘ chemische Spezies des Plasmas, die Kohlenstoff enthalten, das aus CxHy stammt, einen kohlenstoffhaltigen Film (271) insbesondere an den Oberflächen bilden, die parallel zur Implantationshauptrichtung (351) verlaufen;
∘ das Plasma eine Bombardierung mit Ionen schwerer als Wasserstoff schafft, welche die chemischen Spezies des Plasmas, die Kohlenstoff enthalten und aus CxHy stammen, daran hindert, einen kohlenstoffhaltigen Film (271) insbesondere an den Oberflächen der Schutzschicht (152) zu bilden, die senkrecht zur Implantationshauptrichtung (351) verlaufen;
- zumindest einen Schritt des Entfernens (440) der modifizierten Schutzschicht (158) mit Hilfe einer selektiven Ätzung der modifizierten Schutzschicht (158) gegenüber der nicht modifizierten Abschnitte (152a, 152b) der Schutzschicht (152).

2. Verfahren nach Anspruch 1, wobei die Schutzschicht (152) eine Dielektrizitätskonstante unter 4 und vorzugsweise unter 3.1 und bevorzugt unter oder gleich 2 aufweist.

3. Verfahren nach einem der vorangehenden Ansprüche, wobei die Schutzschicht (152) eine Schicht auf Basis von Nitrid (N) und vorzugsweise eine Siliciumnitridschicht (SiN) ist.

4. Verfahren nach einem der Ansprüche 1 oder 2, wobei die Schutzschicht (152) eine Schicht auf Basis von Silicium (Si) oder auf Basis von Kohlenstoff (C) ist und wobei das Material der Schutzschicht (152) ausgewählt ist aus: SiCO, SiC, SiCN, SiOCN, SiCBN, SiOCH, CBN, Bn, SiCBO und SiO2.

5. Verfahren nach einem der vorangehenden Ansprüche, wobei die Schutzschicht (152) eine poröse Schicht ist.

6. Verfahren nach einem der vorangehenden Ansprüche, wobei der Schritt des Ausbildens (410) der Schutzschicht (152) einen Schritt des Aufbringens der Schutzschicht (152) umfasst, bei dem ein Schritt der Verringerung der Dielektrizitätskonstante der Schutzschicht (152) erfolgt und wobei vorzugsweise der Schritt des Verringerns der Dielektrizitätskonstante der Schutzschicht (152) das Einbringen einer Porosität in die Schutzschicht (152) umfasst und/oder wobei der Schritt des Ausbildens (410) der Schutzschicht (152) das Einbringen von Vorläufern in die Schutzschicht (152) während des Aufbringens umfasst.

7. Verfahren nach Anspruch 1, wobei der Schritt des Ausbildens (410) der Schutzschicht (152) einen Schritt des Aufbringens der Schutzschicht (152) umfasst, während dessen ein Schritt des Verringerns der Dielektrizitätskonstante der Schutzschicht (152) erfolgt, wobei der Schritt des Ausbildens (410) der Schutzschicht (152) das Einbringen von Vorläufern in die Schutzschicht (152) während des Aufbringens umfasst, wobei die Schutzschicht eine Schicht auf Basis von Siliciumnitrid ist und wobei die Vorläufer so ausgewählt sind, dass weniger polare Bindungen als Siliciumnitrid, wie etwa Si-F, SiOF, Si-O, C-C, C-H und Si-CH3, bilden.

8. Verfahren nach einem der vorangehenden Ansprüche, wobei bei dem Schritt des Modifizierens (430) der Schutzschicht (152) die CxHy-Konzentration in dem Plasma zwischen 2 % und 50 % und vorzugsweise zwischen 8 % und 40 % beträgt und wobei vorzugsweise bei dem Schritt des Modifizierens (430) der Schutzschicht (152) die Konzentration an schweren Ionen als Wasserstoff in dem Plasma zwischen 50 % und 98 % beträgt.

9. Verfahren nach einem der vorangehenden Ansprüche, das vor dem Schritt des Modifizierens (430) einen Schritt des Aufbringens (310) einer kohlenstoffhaltigen Schicht (311) umfasst, wobei diese kohlenstoffhaltige Schicht (311) gesondert vom Transistor (200) vorliegt, und wobei das Ätzen der modifizierten Schutzschicht (158) selektiv gegenüber dem Kohlenstoff (271) und gegenüber den nicht modifizierten Abschnitten (152a, 152b) der Schutzschicht (152) erfolgt.

10. Verfahren nach dem vorangehenden Anspruch, wobei die kohlenstoffhaltige Schicht (311) dazu ausgelegt ist, eine von dem Transistor (200) gesondert vorliegende Struktur (300) zu überdecken und wobei der Transistor (200) ein NMOS-Transistor ist und die Struktur (300) ein PMOS-Transistor ist, oder wobei der Transistor (200) ein PMOS-Transistor ist und die Struktur (300) ein NMOS-Transistor ist.

11. Verfahren nach einem der vorangehenden Ansprüche, wobei der Schritt des Modifizierens (430) so erfolgt, dass das Plasma eine Bombardierung mit schwereren Ionen als Wasserstoff in anisotroper Weise in der parallel zu den Flanken des Gates (120) verlaufenden Implantationshauptrichtung erzeugt, so dass die chemischen Spezies des Plasmas, die Kohlenstoff enthalten und aus CxHy stammen, daran gehindert werden, einen kohlenstoffhaltigen Film (271) an den Oberflächen zu bilden, die senkrecht zu den Flanken des Gates (120) verlaufen.

12. Verfahren nach einem der vorangehenden Ansprüche, wobei der Schritt des Modifizierens (430) so erfolgt, dass die schwereren Plasmaionen als Wasserstoff das Molekül von CxHy dissoziieren, so dass den aus CxHy stammenden Wasserstoff-Ionen (H) ermöglicht wird, Ionen auf Basis von Wasserstoff zu bilden und sich in den Abschnitten (158) der Schutzschicht (152) zu implantieren.

13. Verfahren nach einem der vorangehenden Ansprüche, wobei beim dem Schritt des Modifizierens (430) die Plasmabedingungen, insbesondere die CxHy-Konzentration, die Energie der Ionen und die Implantationshauptrichtung, so gewählt sind, dass im Bereich der Oberflächen, die senkrecht zur Implantationshauptrichtung verlaufen, die gesamte Dicke der Schutzschicht (152) durch die Implantation von Ionen auf Basis von Wasserstoff modifiziert wird und wobei der Schritt des Entfernens (440) so erfolgt, dass die gesamte modifizierte Schutzschicht (158) entfernt wird, wobei dadurch die Wirkschicht (146) im Bereich der senkrecht zur Implantationshauptrichtung verlaufenden Flächen freigelegt wird.

14. Verfahren nach einem der vorangehenden Ansprüche, wobei der Schritt des Entfernens (440) der modifizierten Schutzschicht (158) durch Nassätzen erfolgt.

15. Verfahren nach einem der Ansprüche 1 bis 13, wobei der Schritt des Entfernens (440) durch selektives Trockenätzen der modifizierten Schutzschicht (158) gegenüber dem kohlenstoffhaltigen Film (271), gegenüber den nicht modifizierten Abschnitten (152a, 152b) der Schutzschicht (152) und gegenüber dem Halbleitermaterial erfolgt, wobei vorzugsweise das Trockenätzen in einem Plasma erfolgt, das in einem Sicherheitsbehälter ausgehend von Stickstofftrifluorid (NF3) und Ammoniak (NH3) gebildet wird, und wobei vorzugsweise das Trockenätzen umfasst:
- einen Schritt des Ätzens (620), der in der Bildung von festen Salzen besteht;
- einen Schritt der Sublimation (630) der festen Spezies.

## Claims

1. Method for forming spacers (152a, 152b) of a gate (120) of a field-effect transistor (200), the gate (120) comprising a top and sides and being located above an active layer (146) made of a semiconductor material, **characterised in that** it comprises:
- at least one step (410) of forming a protective layer (152) covering the gate (120), the protective layer (152) being a layer containing nitride (N) and/or containing silicon (Si) and/or containing carbon (C) that has a dielectric constant less than or equal to 8;
- at least one step (430) of modifying the protective layer (152) by placing the protective layer (152) in the presence of a plasma into which CxHy is introduced, where x is the proportion of carbon (C) and y is the proportion of hydrogen (H), and comprising ions heavier than hydrogen; the conditions of the plasma, in particular the concentration of CxHy, the energy of the plasma ions and the main direction of implantation being chosen in such a way that:
-- the plasma creates a bombardment of ions made from hydrogen (H, H⁺, H₂⁺, H₃⁺, etc.) from the CxHy, the bombardment being anisotropic in the main direction of implantation that is parallel to the sides of the gate (120), in such a way as to form a modified protective layer (158) by modifying portions (158) of the protective layer (152) located on the top of the gate (120) and on either side of the gate (120) and in such a way as to preserve non-modified portions (152a, 152b) of the protective layer (152) covering the sides of the gate (120),
-- chemical species of the plasma containing carbon from the CxHy form a carbon film (271) in particular on surfaces parallel to the main direction (351) of implantation;
-- the plasma creates a bombardment of the ions heavier than hydrogen that prevents said chemical species of the plasma containing carbon and coming from the CxHy from forming a carbon film (271) in particular on the surfaces of the protective layer (152) that are perpendicular to the main direction (351) of implantation;
- at least one step (440) of removing the modified protective layer (158) via selective etching of the modified protective layer (158) with respect to the non-modified portions (152a, 152b) of the protective layer (152).

2. Method according to claim 1, wherein the protective layer (152) has a dielectric constant of less than 4 and preferably less than 3.1 and preferably less than or equal to 2.

3. Method according to any one of the previous claims, wherein the protective layer (152) is a layer containing nitride (N) and preferably a layer of silicon nitride (SiN).

4. Method according to any one of claims 1 and 2, wherein the protective layer (152) is a layer containing silicon (Si) or containing carbon (C) or wherein the material of the protective layer (152) is chosen from: SiCO, SiC, SiCN, SiOCN, SiCBN, SiOCH, CBN, BN, SiCBO and SiO2.

5. Method according to any one of the previous claims, wherein the protective layer (152) is a porous layer.

6. Method according to any one of the previous claims, wherein the step (410) of forming the protective layer (152) comprises a step of depositing the protective layer (152) during which a step of reducing the dielectric constant of the protective layer (152) is carried out and preferably wherein the step of reducing the dielectric constant of the protective layer (152) comprises the introduction of porosity into the protective layer (152) and/or wherein the step (410) of forming the protective layer (152) comprises the introduction of precursors into the protective layer (152) being deposited.

7. Method according to claim 1, wherein the step (410) of forming the protective layer (152) comprises a step of depositing the protective layer (152) during which a step of reducing the dielectric constant of the protective layer (152) is carried out, wherein the step (410) of forming the protective layer (152) comprises the introduction of precursors into the protective layer (152) being deposited, wherein the protective layer is a layer containing silicon nitride and wherein the precursors are chosen in such a way as to form bonds that are less polar than silicon nitride, such as Si-F, SiOF, Si-O, C-C, C-H, and Si-CH3.

8. Method according to any one of the previous claims, wherein during said step (430) of modifying the protective layer (152), the concentration of CxHy in the plasma is between 2% and 50% and preferably between 8% and 40% and preferably wherein during said step (430) of modifying the protective layer (152), the concentration of ions heavier than hydrogen in the plasma is between 50% and 98%.

9. Method according to any one of the previous claims, comprising, before the step (430) of modification, a step (310) of depositing a layer (311) comprising carbon, this layer (311) comprising carbon being distinct from said transistor (200), and wherein said etching is selective for the modified protective layer (158) with respect to the carbon (271) and with respect to the non-modified portions (152a, 152b) of the protective layer (152).

10. Method according to the previous claim, wherein the layer (311) comprising carbon is configured to cover a structure (300) distinct from said transistor (200) and wherein said transistor (200) is an NMOS transistor and said structure (300) is a PMOS transistor, or wherein said transistor (200) is a PMOS transistor and said structure (300) is an NMOS transistor.

11. Method according to any one of the previous claims, wherein the step (430) of modification is carried out in such a way that the plasma generates a bombardment of the ions heavier than hydrogen in a manner that is anisotropic in the main direction of implantation parallel to the sides of the gate (120) in such a way as to prevent said chemical species of the plasma containing carbon coming from the CxHy from forming a carbon film (271) on the surfaces perpendicular to the sides of the gate (120).

12. Method according to any one of the previous claims, wherein the step (430) of modification is carried out in such a way that the ions heavier than hydrogen of the plasma dissociate the molecule of the CxHy in such a way as to allow the hydrogen ions (H) coming from the CxHy to form ions made from hydrogen and be implanted in said portions (158) of the protective layer (152).

13. Method according to any one of the previous claims, wherein during the step (430) of modification, the conditions of the plasma, in particular the concentration of CxHy, the energy of the ions and the main direction of implantation are chosen in such a way that, at the surfaces perpendicular to the main direction of implantation, the entire thickness of the protective layer (152) is modified by the implantation of the ions made from hydrogen and wherein the step (440) of removal is carried out in such a way as to remove all of the modified protective layer (158), thus exposing the active layer (146) at the surfaces perpendicular to the main direction of implantation.

14. Method according to any one of the previous claims, wherein the step (440) of removing the modified protective layer (158) is carried out via wet etching.

15. Method according to any one of claims 1 to 13, wherein the step (440) of removal is carried out via dry etching selective for said modified protective layer (158) with respect to said carbon film (271), with respect to the non-modified portions (152a, 152b) of the protective layer (152) and with respect to said semiconductor material, preferably wherein the dry etching is carried out in a plasma formed in a confined chamber from nitrogen trifluoride (NF3) and ammonia (NH3) and preferably wherein the dry etching comprises:
- a step (620) of etching consisting of the formation of solid salts;
- a step (630) of sublimation of the solid species.
